# EUROPEAN PATENT APPLICATION

(11) **EP 4 668 269 A1**
(43) Date of publication of application: **24.12.2025**
(21) Application number: 25181984.3
(22) Date of filing: 11.06.2025
(51) Int. Cl.: G11C 5/02, G11C 11/4091, H10B 12/00

(54) **MEMORY DEVICE**

(30) Priority: 20.06.2024 KR 20240080251
(71) Applicant: Samsung Electronics Co., Ltd., Suwon-si, Gyeonggi-do 16677 (KR)
(72) Inventor: KIM, YONGJUN, 16677 Suwon-si, Gyeonggi-do (KR); IHM, Jeongdon, 16677 Suwon-si, Gyeonggi-do (KR); PARK, Young Seok, 16677 Suwon-si, Gyeonggi-do (KR); YOON, Hyun-Chul, 16677 Suwon-si, Gyeonggi-do (KR)
(74) Representative: Kuhnen & Wacker Patent- und Rechtsanwaltsbüro PartG mbB

(57) **Abstract**

A memory device is provided. The memory device includes a memory cell region including a first sub-memory array (SMA11) and a second sub-memory array (SMA12) arranged in a first direction (D2), and a peripheral circuit region including a first local sense amplifier circuit that at least partially overlaps the first and second sub-memory arrays (SMA11, SMA12) in a second direction (D3). The first sub-memory array (SMA11) includes first volatile memory cells electrically connected to a first word line and to respective ones of first bit lines. The second sub-memory array (SMA12) includes second volatile memory cells electrically connected to a second word line and to respective ones of second bit lines. The first local sense amplifier circuit is electrically connected to at least one of the first bit lines and to at least one of the second bit lines. A number of the first bit lines is equal to a number of the second bit lines.

## Description

### BACKGROUND OF THE INVENTION

The present disclosure relates to a memory device.

To increase memory reliability and productivity, memory devices may include arrays of irregularly sized independent cells, such as ECC cell arrays for storing error correction code (ECC) parity bits and redundancy cell arrays for replacing bad memory cells.

The memory devices may include word line drivers, sense amplifier circuits, and the like to drive independent cell arrays of irregular sizes as described above, and it is helpful for the word line drivers, sense amplifier circuits, and the like to be efficiently arranged to reduce the overall size of the memory device.

### SUMMARY OF THE INVENTION

Embodiments of the present disclosure provide a memory device having a cell on peripheral (COP) structure with improved area efficiency.

According to aspects of the present disclosure, a memory device includes a memory cell region comprising a first sub-memory array and a second sub-memory array arranged in a first direction, wherein the first sub-memory array comprises a plurality of first volatile memory cells electrically connected to a first word line extending in the first direction and to respective ones of a plurality of first bit lines, and wherein the second sub-memory array comprises a plurality of second volatile memory cells electrically connected to a second word line extending in the first direction and to respective ones of a plurality of second bit lines; and a peripheral circuit region comprising a first local sense amplifier circuit that at least partially overlaps the first sub-memory array and the second sub-memory array in a second direction orthogonal to the first direction, wherein the first local sense amplifier circuit is electrically connected to at least one of the first bit lines and to at least one of the second bit lines, and wherein a number of the first bit lines is equal to a number of the second bit lines.

According to aspects of the present disclosure, a memory device includes a memory cell region comprising a plurality of sub-memory arrays arranged in a first direction and divided into a first row block based on one or more bits included in a row address, wherein the plurality of sub-memory arrays comprise a word line extending in the first direction and a plurality of volatile memory cells electrically connected to a plurality of bit lines; and a peripheral circuit region comprising a first local sense amplifier circuit and a second local sense amplifier circuit, wherein the first local sense amplifier circuit at least partially overlaps one or more of the sub-memory arrays in a second direction orthogonal to the first direction, is electrically connected to first ones of the bit lines, and is configured to output data, wherein a number of the first ones of the bit lines is different from a number of the bit lines included in a respective one of the sub-memory arrays, wherein the second local sense amplifier circuit at least partially overlaps one or more of the sub-memory arrays in the second direction, is electrically connected to second ones of the bit lines, and is configured to output parity data corresponding to the data, and wherein the number of the first ones of the bit lines is equal to a number of the second ones of the bit lines.

According to aspects of the present disclosure, a memory device includes a memory cell region comprising a first sub-memory array and a second sub-memory array, wherein the first sub-memory array comprises a plurality of first volatile memory cells electrically connected to a first word line extending in a first direction and to respective ones of a plurality of first bit lines, and wherein the second sub-memory array comprises a plurality of second volatile memory cells electrically connected to a second word line extending in the first direction and to respective ones of a plurality of second bit lines; and a peripheral circuit region comprising a first local sense amplifier circuit that is electrically connected to at least one of the first bit lines, wherein the first local sense amplifier circuit at least partially overlaps the first sub-memory array in a second direction orthogonal to the first direction, wherein a number of the first bit lines is equal to a number of the second bit lines, wherein the first volatile memory cells are configured to store data, and wherein first ones of the second volatile memory cells are configured to store parity data corresponding to the data.

According to aspects of the present disclosure, a memory device includes a memory cell region comprising a first sub-memory array including a plurality of first volatile memory cells that are electrically connected to a first word line extending in a first direction and to respective ones of a plurality of first bit lines, and a second sub-memory array arranged with the first sub-memory array in the first direction, the second sub-memory array including a plurality of second volatile memory cells that are electrically connected to a second word line extending in the first direction and to respective ones of a plurality of second bit lines; a peripheral circuit region comprising a first local sense amplifier circuit that is electrically connected to at least one of the first bit lines and at least one of the second bit lines; and a contact plug extending from an external pad located on an upper surface of the memory cell region, extending in at least a portion of the memory cell region, and electrically connected to a circuit element in the peripheral circuit region, wherein a number of the first bit lines is equal to a number of the second bit lines.

### BRIEF DESCRIPTION OF THE DRAWINGS

FIG. 1 is a block diagram illustrating a memory system according to some embodiments.
FIG. 2 is a block diagram illustrating a memory device according to some embodiments.
FIG. 3 is a block diagram for describing an ECC engine according to some embodiments.
FIG. 4 is a perspective view illustrating a memory device according to some embodiments.
FIG. 5 is a top plan view for describing a bank array according to some embodiments.
FIG. 6 is a top plan view for describing a first row block of FIG. 5.
FIG. 7 is a circuit diagram illustrating a part of a first bank array of FIG. 5 in detail.
FIG. 8 is a cross-sectional view taken along line C-C' of the memory device of FIG. 4.
FIG. 9 is an enlarged view of region AA of FIG. 8.
FIG. 10 is a top plan view for describing a bank array according to some embodiments.
FIG. 11 is a top plan view for describing the first row block of FIG. 10.
FIG. 12 is a top plan view for describing a bank array according to some embodiments.
FIG. 13 is a top plan view for describing the first row block of FIG. 12.
FIG. 14 is a cross-sectional view taken along line C-C' of the memory device of FIG. 4.
FIG. 15 is a block diagram illustrating a computer device according to some embodiments.

### DETAILED DESCRIPTION

The present disclosure will be described in detail hereinafter with reference to the accompanying drawings, in which example embodiments of the present disclosure are shown. As those skilled in the art will realize, the described embodiments may be modified in various different ways, all without departing from the scope of the present disclosure.

The drawings and description are to be regarded as illustrative in nature and not restrictive. Like reference numerals designate like elements throughout the specification.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

In this specification, "a module", "a unit", or "a part" may perform at least one function or operation, and may be realized as hardware, such as a processor or integrated circuit, software that is executed by a processor, or a combination thereof (e.g., firmware).

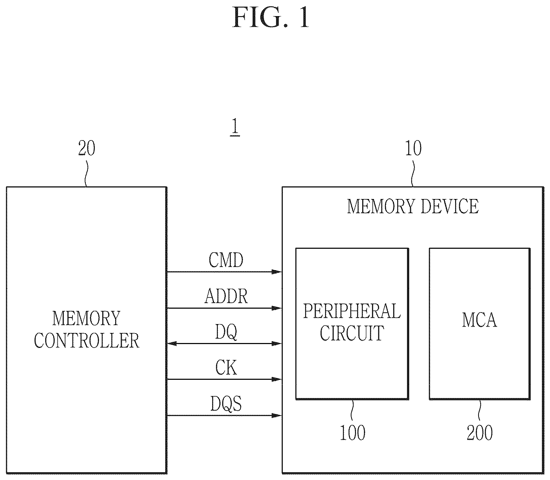

FIG. 1 is a block diagram illustrating a memory system according to some embodiments.

Referring to FIG. 1, a memory system 1 may include a memory device 10 and a memory controller 20.

The memory controller 20 generally controls the operation of the memory system 1 and overall data exchange between the external host and the memory device 10. For example, the memory controller 20 controls the memory device 10 to write data or read data according to a host's request.

Additionally, the memory controller 20 controls the operation of the memory device 10 by applying operation commands to control the memory device 10. Depending on the embodiments, the memory device 10 may be dynamic random access memory (DRAM), double data rate 5 (DDR5) synchronous DRAM (SDRAM), or DDR6 SDRAM having volatile memory cells.

The memory controller 20 may include a processor that controls the overall operation of the memory controller 20, and the memory controller 20 may control the memory device 10 based on the operation of the processor. The memory controller 20 may transmit a clock signal (CK, or command clock signal), a command CMD, and an address ADDR to the memory device 10. When transmitting a data signal DQ to the memory device 10 or receiving the data signal DQ from the memory device 10, the memory controller 20 may exchange a data strobe signal DQS with the memory device 10. The address ADDR may be accompanied by the command CMD, and the address ADDR may be referred to as an access address in the present disclosure.

The memory device 10 may include a peripheral circuit 100 and a memory cell array 200 that stores data. The peripheral circuit 100 may control the operation of the memory cell array 200. The memory cell array 200 may include a plurality of bank arrays, and each bank array may include a plurality of sub-memory arrays including a plurality of volatile memory cells. Additionally, each bank array is divided into a plurality of row blocks by row block identification bits, which are some bits of the row address, and each row block may include a plurality of sub-memory arrays arranged in one direction.

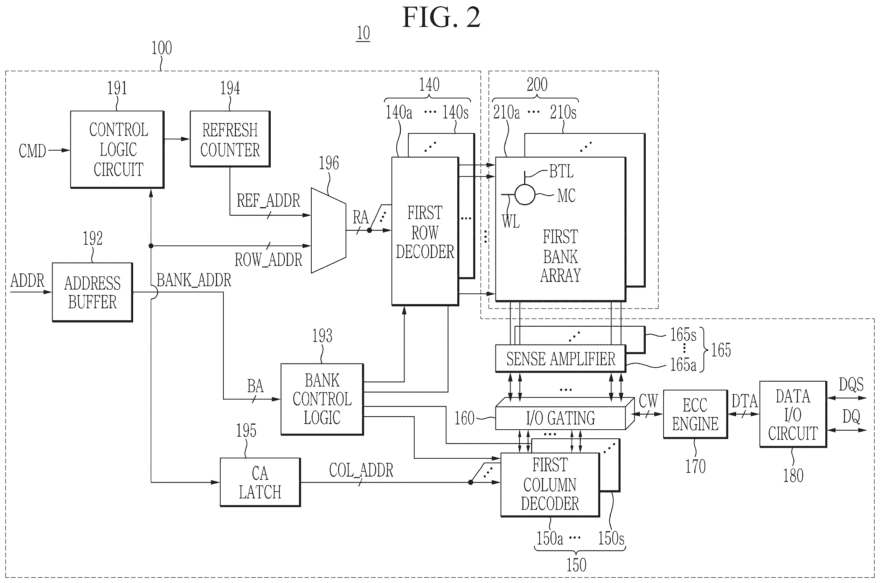

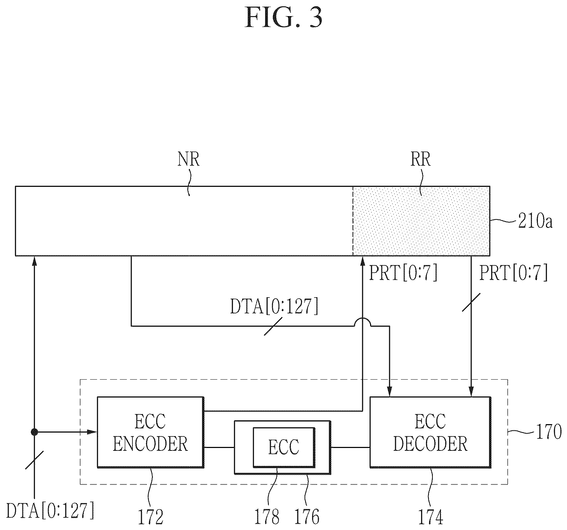

FIG. 2 is a block diagram illustrating a memory device according to some embodiments. FIG. 3 is a block diagram for describing an ECC engine according to some embodiments.

Referring to FIGS. 1 to 3, the memory device 10 may include a peripheral circuit 100 and a memory cell array 200. The peripheral circuit 100 may include a control logic circuit 191, an address register 192 (i.e., address buffer), a bank control logic 193, a refresh counter 194, a column address latch 195, a row address multiplexer 196, a row decoder 140, a column decoder 150, a sense amplifier 165, an input/output gating circuit 160, an ECC engine 170, and a data input/output buffer 180.

The memory cell array 200 may include first to sixteenth bank arrays 210a to 210s. The row decoder 140 may include first to sixteenth row decoders 140a to 140s respectively connected to the first to sixteenth bank arrays 210a to 210s, the column decoder 150 may include first to sixteenth column decoders 150a to 150s respectively connected to the first to sixteenth bank arrays 210a to 210s, and the sense amplifier 165 may include first to sixteenth sense amplifiers 165a to 165s respectively connected to the first to sixteenth bank arrays 210a to 210s.

The first to sixteenth bank arrays 210a to 210s, the first to sixteenth sense amplifiers 165a to 165s, the first to sixteenth column decoders 150a to 150s, and first to sixteenth row decoders 140a to 140s can operate as the first to sixteenth banks. Each of the first to sixteenth bank arrays 210a to 210s may include a plurality of word lines WL, a plurality of bit lines BTL, and a plurality of memory cells MC disposed at intersections of the word lines WL and the bit lines BTL. Although the memory device 10 is shown in FIG. 2 as including 16 banks, the present disclosure is not limited thereto.

Each of the first to sixteenth bank arrays 210a to 210s may include a plurality of memory cells MC, which are a plurality of volatile memory cells that store data. In addition, each of the first to sixteenth bank arrays 210a to 210s may include a plurality of sub-memory arrays, and the plurality of sub-memory arrays may be divided into a plurality of row blocks by row block identification bits, which are some bits of the row address. The row block may include a plurality of sub-memory arrays arranged in one direction.

The control logic circuit 191 may control the operation of the memory device 10. For example, the control logic circuit 191 may generate control signals so that the memory device 10 performs a write operation or a read operation. Although not shown, the control logic circuit 191 may include a command decoder for decoding the received command CMD and a mode register for setting the operation mode of the memory device 10. For example, the command decoder may decode a chip selection signal and a command/address signal to generate the control signals corresponding to the command CMD. In particular, the command decoder may decode the command CMD and generate a control signal for controlling the input/output gating circuit 160 and the ECC engine 170.

The address register 192 may receive the address ADDR including a bank address BANK_ADDR, a row address ROW_ADDR, and a column address COL_ADDR from the memory controller 20. The address register 192 may provide the received bank address BANK_ADDR to the bank control logic 193, the received row address ROW_ADDR to the row address multiplexer 196, and the received column address COL_ADDR to the column address latch 195.

The bank control logic 193 may generate a bank control signal in response to the bank address BANK_ADDR. In response to the bank control signal, the row decoder corresponding to the bank address BANK_ADDR among the first to sixteenth row decoders 140a to 140s may be activated, and the column decoder corresponding to the bank address BANK_ADDR among the first to sixteenth column decoders 150a to 150s may be activated.

The row address multiplexer 196 may receive the row address ROW _ADDR from the address register 192 and a refresh row address REF_ADDR from the refresh counter 194. The row address multiplexer 196 may selectively output the row address ROW_ADDR or the refresh row address REF_ADDR as a row address RA. The row address RA output from the row address multiplexer 196 may be applied to the first to sixteenth row decoders 140a to 140s, respectively.

Among the first to sixteenth row decoders 140a to 140s, the row decoder activated by the bank control logic 193 may decode the row address RA output from the row address multiplexer 196 to activate the word line corresponding to the row address. Although not shown, each of the first to sixteenth row decoders 140a to 140s may include a plurality of sub-word line driving drivers. For example, the sub-word line driving driver in the activated row decoder may apply a word line driving voltage to the word line corresponding to the row address RA.

The column address latch 195 may receive the column address COL_ADDR from the address register 192 and temporarily store the received column address COL_ADDR. Additionally, the column address latch 195 may gradually increase the received column address COL_ADDR in burst mode. The column address latch 195 may apply the temporarily stored or gradually increased column address COL_ADDR to the first to sixteenth column decoders 150a to 150s, respectively.

Among the first to sixteenth column decoders 150a to 150s, the column decoder activated by the bank control logic 193 may activate the sense amplifier corresponding to the bank address BANK_ADDR and the column address COL_ADDR through the corresponding input/output gating circuit 160.

Along with circuits for gating input/output data, the input/output gating circuit 160 may include input data mask logic, read data latches for storing codewords output from the first to sixteenth bank arrays 210a to 210s, and write drivers for writing data to the first to sixteenth bank arrays 210a to 210s.

A codeword CW read from one of the first to sixteenth bank arrays 210a to 210s may be detected by a sense amplifier corresponding to the one bank array and stored in the read data latch. The codeword CW stored in the lead data latch may be ECC decoded by the ECC engine 170 and provided as data DTA to the data input/output buffer 180, which may convert the data DTA into the data signal DQ based on the data DTA and provide the data signal DQ to the memory controller 20 along with the strobe signal DQS.

The data signal DQ to be written in one of the first to sixteenth bank arrays 210a to 210s is received by the data input/output buffer 180 together with the strobe signal DQS. The data input/output buffer 180 may convert the data signal DQ into the data DTA and provide the data DTA to the ECC engine 170. The ECC engine 170 may generate parity data (or parity bits) based on the data DTA, and provide the codeword CW including the data DTA and the parity data to the input/output gating circuit 160. The input/output gating circuit 160 may write the codeword CW to the target page of the one bank array through the write drivers.

In a write operation, the data input/output buffer 180 may convert the data signal DQ into the data DTA and provide the data DTA to the ECC engine 170. In a read operation, the data input/output buffer 180 may convert the data DTA provided from the ECC engine 170 into the data signal DQ, and may provide the data signal DQ and the strobe signal DQS to the memory controller 20.

The ECC engine 170 may perform ECC encoding for the data DTA and ECC decoding for the codeword CW based on the control signal provided from the control logic circuit 191.

The ECC engine 170 may include an ECC encoder 172, an ECC decoder 174, and a memory 176. The memory 176 may store an ECC 178. The ECC 178 may be a single error correction (SEC) code or a single error correction and double error detection (SECDED) code, but is not limited thereto.

The ECC encoder 172 may use the ECC 178 to generate 8-bit parity data PRT corresponding to 128-bit data DTA for the codeword CW. The parity data PRT may be stored in a redundancy region RR of the first bank array 210a. The data DTA may be stored in a normal region NR of the first bank array 210a. Depending on the embodiments, the ratio of the number of bits of parity data PRT to the number of bits of data DTA may be 1 to 16. In FIG. 3, the number of bits of data DTA is 128 and the number of bits of corresponding parity data PRT is 8, but the number of bits is not limited thereto and the number of bits may vary. For example, if the number of bits of the data DTA is 256, the number of bits of the parity data PRT may be 16.

The ECC decoder 174 may use the ECC 178 to perform ECC decoding on the data DTA read from the first bank array 210a based on the parity data PRT read from the first bank array 210a. If the read data DTA as a result of ECC decoding includes one error bit, the ECC decoder 174 may correct one error bit and provide corrected data (C_DTA) to the data input/output buffer 180.

In FIG. 3, the parity data PRT is shown to be stored in the redundancy region RR, but the present disclosure is not limited thereto, and according to some embodiments, the redundancy region RR may include a redundancy cell array for replacing defective cells in the normal region NR.

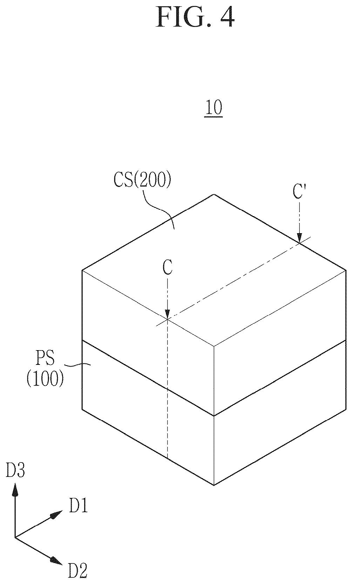

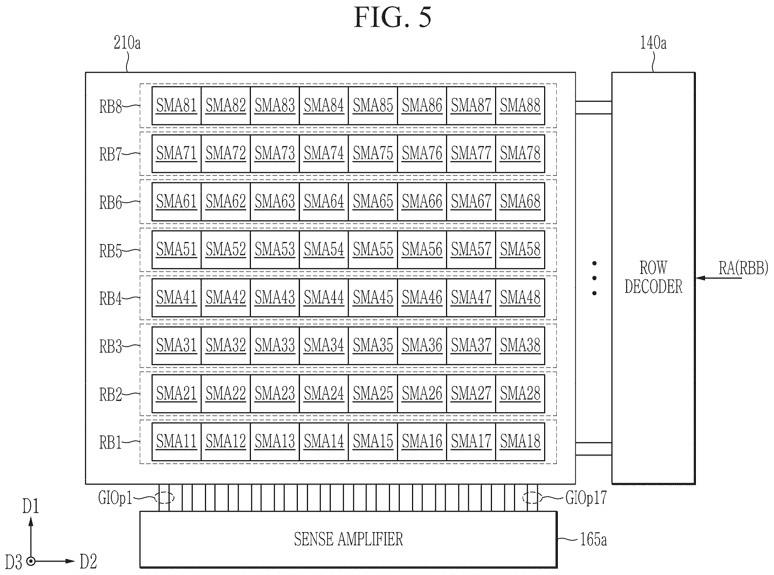

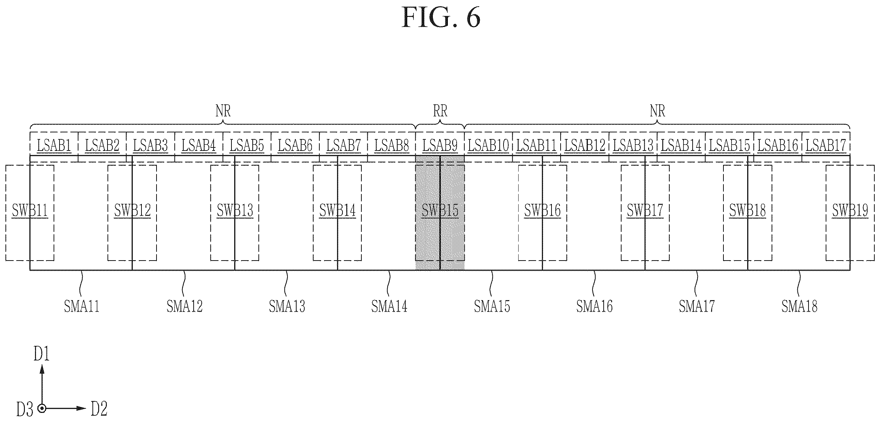

FIG. 4 is a perspective view illustrating a memory device according to some embodiments. FIG. 5 is a top plan view for describing a bank array according to some embodiments. FIG. 6 is a top plan view for describing a first row block of FIG. 5.

Referring to FIGS. 2 and 4 to 6, depending on embodiments, the memory device 10 may include a peripheral circuit region PS and a memory cell region CS. The memory device 10 may have a cell on peripheral (COP) structure, and the peripheral circuit region PS and the memory cell region CS may be three-dimensionally stacked in a third direction D3 (which is an example for the "second direction" in the claims). The memory cell region CS may be a region where the memory cell array 200 is disposed, and the peripheral circuit region PS may be a region where the peripheral circuit 100 that controls the operation of the memory cell array 200 is disposed.

At least a part of the peripheral circuit region PS may overlap the memory cell region CS on a plane along the third direction D3. As used herein, "an element A overlaps an element B in a direction X" (or similar language) means that there is at least one straight line that extends in the direction X and intersects both the elements A and B. Depending on the embodiments, the peripheral circuit region PS may include a part of an external pad (not shown) or a wiring body (not shown) disposed on the memory cell region CS.

The memory cell region CS may include the memory cell array 200, and the memory cell array 200 may include the first to sixteenth bank arrays 210a to 210s. The first to sixteenth bank arrays 210a to 210s may be arranged to non-overlap each other (i.e., to be free of overlap with each other) on a plane along the third direction D3. Depending on the embodiments, the first to sixteenth bank arrays 210a to 210s may be arranged on the same plane.

Hereinafter, the components and arrangement of the components within the memory device 10 will be described based on the first bank array 210a. It will be understood that the description of the first bank array 210a may be applied in the same or similar manner to the rest of the bank arrays 210a to 210s.

The first bank array 210a may include a plurality of sub-memory arrays SMA11 to SMA88. The plurality of sub-memory arrays SMA11 to SMA88 may be connected to the first row decoder 140a and the first sense amplifier 165a. The first row decoder 140a may include a plurality of sub-word line drivers, and among the plurality of sub-word line drivers, a sub-word line driver corresponding to the row address RA may be activated. The activated sub-word line driver may provide a driving voltage to the word line corresponding to the row address RA.

The first sense amplifier 165a may be connected to the plurality of sub-memory arrays SMA11 to SMA88 through first to seventeenth global input/output line pairs GIOp1 to GIOp17. Depending on the embodiments, any one of the first to seventeenth global input/output line pairs GIOp1 to GIOp17 connected to the first sense amplifier 165a may be connected to local sense amplifier circuits arranged in the second direction D2.

For example, among the local sense amplifier circuits connected to 1_1 to 8_1 sub-memory arrays SMA11 to SMA81, some of the local sense amplifier circuits arranged in a first direction D1 (which is an example for the "third direction" in the claims) may be connected to the first sense amplifier 165a through the first global input/output line pair GIOp1.

In FIG. 5, the first sense amplifier 165a and the first row decoder 140a are shown as arranged to non-overlap on a plane with the first bank array 210a, but the arrangement of the first sense amplifier 165a and the first row decoder 140a shown in FIG. 5 is for describing the connection relationship with the components. Depending on the embodiments, at least a part of the first sense amplifier 165a and at least a part of the first row decoder 140a may overlap the first bank array 210a in the third direction D3.

The plurality of sub-memory arrays SMA11 to SMA88 may be divided into first to eighth row blocks RB1 to RB8 arranged in the first direction D1 by a row block identification bits RBB, which are some bits of the row address RA. For example, by the row block identification bit RBB, which is the upper 3 bits of the row address RA, the plurality of sub-memory arrays SMA11 to SMA88 may be divided into the first to eighth row blocks RB1 to RB8 arranged in the first direction D1. Although the first bank array 210a of FIG. 5 includes a plurality of sub-memory arrays arranged in 8 row blocks and 8 column blocks, the present disclosure is not limited thereto, and the number of row blocks and column blocks included in the bank array may vary depending on the embodiments. In the present disclosure, a "row block" refers to a set of a plurality of sub-memory arrays arranged in a second direction D2 (which is an example for the "first direction" in the claims) in which the word line extends, and a "column block" refers to a set of sub-memory arrays arranged in the first direction D1 in which the bit line extends.

The first row block RB1 may include 1_1 to 1_8 sub-memory arrays SMA11 to SMA18 that are divided into the same row block by the row block identification bit RBB. The 1_1 to 1_8 sub-memory arrays SMA11 to SMA18 may be arranged in the second direction D2. Hereinafter, the components and arrangement of the components within the first bank array 210a will be described based on the first row block RB1. It will be understood that the description of the first row block RB1 may be applied in the same or similar manner to the rest of the row blocks RB1 to RB8.

Each of the 1_1 to 1_8 sub-memory arrays SMA11 to SMA18 may include a plurality of word lines extending in the second direction D2, a plurality of bit lines extending in the first direction D1, and memory cells connected to the plurality of word lines and the plurality of bit lines.

Depending on the embodiments, the 1_1 to 1_8 sub-memory arrays SMA11 to SMA18 may include a predetermined first number of word lines, and a predetermined second number of bit lines that intersect one word line. Each of the 1_1 to 1_8 sub-memory arrays SMA11 to SMA18 may include the same number of word lines and the same number of bit lines. The number of memory cells connected to one word line in the 1_1 to 1_8 sub-memory arrays SMA11 to SMA18 is the same. For example, the number of memory cells connected to one word line of the 1_1 sub-memory array SMA11 is equal to the number of memory cells connected to one word line of the 1_2 sub-memory array SMA12. For example, memory cells connected to one word line of the 1_1 sub-memory array SMA11 may be respectively connected to bit lines of the 1_1 sub-memory array SMA11. In other words, memory cells connected to one word line of the 1_1 sub-memory array SMA11 may be connected to respective ones of the bit lines of the 1_1 sub-memory array SMA11.

Referring to FIG. 6, the 1_1 sub-memory array SMA11 may be arranged to overlap at least a part of a 1_1 sub-word line driver region SWB11 and at least a part of a 1_2 sub-word line driver region SWB12 in the third direction D3. Depending on the embodiments, the 1_1 sub-memory array SMA11 may include word lines connected to at least a part of the sub-word line driver disposed in the 1_1 sub-word line driver region SWB11 and to at least a part of the sub-word line driver disposed in the 1_2 sub-word line driver region SWB12. For example, the first direction D1, the second direction D2, and the third direction D3 may be orthogonal to each other.

The 1_2 sub-memory array SMA12 may be arranged to overlap at least a part of the 1_2 sub-word line driver region SWB 12 and at least a part of a 1_3 sub-word line driver region SWB13 in the third direction D3. Depending on the embodiments, the 1_2 sub-memory array SMA12 may include word lines connected to at least a part of the sub-word line driver disposed in the 1_2 sub-word line driver region SWB 12 and to at least a part of the sub-word line driver disposed in the 1_3 sub-word line driver region SWB13.

A 1_3 sub-memory array SMA13 may be arranged to overlap at least a part of the 1_3 sub-word line driver region SWB 13 and at least a part of a 1_4 sub-word line driver region SWB14 in the third direction D3. Depending on the embodiments, the 1_3 sub-memory array SMA13 may include word lines connected to at least a part of the sub-word line driver disposed in the 1_3 sub-word line driver region SWB 13 and to at least a part of the sub-word line driver disposed in the 1_4 sub-word line driver region SWB14.

The 1_4 sub-memory array SMA14 may be arranged to overlap at least a part of the 1_4 sub-word line driver region SWB 14 and at least a part of a 1_5 sub-word line driver region SWB15 in the third direction D3. Depending on the embodiments, the 1_4 sub-memory array SMA14 may include word lines connected to at least a part of the sub-word line driver disposed in the 1_4 sub-word line driver region SWB 14 and to at least a part of the sub-word line driver disposed in the 1_5 sub-word line driver region SWB15.

The 1_5 sub-memory array SMA15 may be arranged to overlap at least a part of the 1_5 sub-word line driver region SWB 15 and at least a part of a 1_6 sub-word line driver region SWB16 in the third direction D3. Depending on the embodiments, the 1_5 sub-memory array SMA15 may include word lines connected to at least a part of the sub-word line driver disposed in the 1_5 sub-word line driver region SWB 15 and to at least a part of the sub-word line driver disposed in the 1_6 sub-word line driver region SWB16.

A 1_6 sub-memory array SMA16 may be arranged to overlap at least a part of the 1_6 sub-word line driver region SWB 16 and at least a part of a 1_7 sub-word line driver region SWB17 in the third direction D3. Depending on the embodiments, the 1_6 sub-memory array SMA16 may include word lines connected to at least a part of the sub-word line driver disposed in the 1_6 sub-word line driver region SWB 16 and to at least a part of the sub-word line driver disposed in the 1_7 sub-word line driver region SWB17.

A 1_7 sub-memory array SMA17 may be arranged to overlap at least a part of the 1_7 sub-word line driver region SWB 17 and at least a part of a 1_8 sub-word line driver region SWB18 in the third direction D3. Depending on the embodiments, the 1_7 sub-memory array SMA17 may include word lines connected to at least a part of the sub-word line driver disposed in the 1_7 sub-word line driver region SWB 17 and to at least a part of the sub-word line driver disposed in the 1_8 sub-word line driver region SWB18.

A 1_8 sub-memory array SMA18 may be arranged to overlap at least a part of the 1_8 sub-word line driver region SWB 18 and at least a part of a 1_9 sub-word line driver region SWB19 in the third direction D3. Depending on the embodiments, the 1_8 sub-memory array SMA18 may include word lines connected to at least a part of the sub-word line driver disposed in the 1_8 sub-word line driver region SWB 18 and to at least a part of the sub-word line driver disposed in the 1_9 sub-word line driver region SWB19.

The 1_1 to 1_9 sub-word line driver regions SWB 11 to SWB19 may be arranged at the boundary between the 1_1 to 1_8 sub-memory arrays SMA11 to SMA18 or on one side of the first row block RB1. The 1_1 to 1_9 sub-word line driver regions SWB11 to SWB19 may be arranged in the second direction D2. Although not specifically shown in FIG. 6, the 1_1 to 1_9 sub-word line driver regions SWB11 to SWB19 may be included in a peripheral circuit region PS (100) of the memory device 10 (e.g., see FIGS. 2 and 4).

Depending on the embodiments, the local sense amplifier circuits included in each of first to seventeenth local sense amplifier regions LSAB1 to LSAB17 may be connected to a predetermined third number of bit lines. The circuit disposed in each of the first to seventeenth local sense amplifier regions LSAB1 to LSAB17 may operate as a single local sense amplifier circuit, amplifying the difference in voltage levels detected in a plurality of bit line pairs and providing the difference to a pair of global input/output lines. Although not specifically shown in FIG. 6, the first to seventeenth local sense amplifier regions LSAB 1 to LSAB17 may be included in a peripheral circuit region PS (100) of the memory device 10 (e.g., see FIGS. 2 and 4).

As used herein, a "local sense amplifier region" may refer to a region in which a local sense amplifier circuit is disposed between a plurality of bit lines and a pair of global input/output lines to perform amplification and transmission of voltage. Each of the local sense amplifier circuits in the first to seventeenth local sense amplifier regions LSAB1 to LSAB17 is connected to the same number of bit lines, and the local sense amplifier circuit may receive differences in amplified voltage levels from some of the bit lines based on a column selection signal. Accordingly, if a "local sense amplifier region" is described to overlap another element or region, it is understood that the corresponding local sense amplifier circuit overlaps the other element or region.

At least a part of the first local sense amplifier region LSAB1 may overlap the 1_1 sub-memory array SMA11 in the third direction D3. The local sense amplifier circuit disposed in the first local sense amplifier region LSAB1 may be connected to at least a part of the bit lines of the 1_1 sub-memory array SMA11, which is the normal region NR. The memory cell in the normal region NR may store data DTA, and the local sense amplifier circuit in the first local sense amplifier region LSAB1 may be connected to the first global input/output line pair GIOp1. The local sense amplifier circuit in the first local sense amplifier region LSAB1 may input and output the data DTA stored by the memory cell in the 1_1 sub-memory array SMA11 through the first global input/output line pair GIOp1.

At least a part of a second local sense amplifier region LSAB2 may overlap the 1_1 sub-memory array SMA11 in the third direction D3. The local sense amplifier circuit disposed in the second local sense amplifier region LSAB2 may be connected to at least a part of the bit lines of the 1_1 sub-memory array SMA11, which is the normal region NR. The memory cell in the normal region NR may store the data DTA, and the local sense amplifier circuit in the second local sense amplifier region LSAB2 may be connected to the second global input/output line pair GIOp2. The local sense amplifier circuit in the second local sense amplifier region LSAB2 may input and output the data DTA stored by the memory cell in the 1_1 sub-memory array SMA11 through the second global input/output line pair GIOp2.

At least a part of a third local sense amplifier region LSAB3 may overlap the 1_1 sub-memory array SMA11 and the 1_2 sub-memory array SMA12 in the third direction D3. The local sense amplifier circuit disposed in the third local sense amplifier region LSAB3 may be connected to at least a part of the bit lines of the 1_1 sub-memory array SMA11, which is the normal region NR, and to at least a part of the bit lines of the 1_2 sub-memory array SMA12. The memory cell in the normal region NR may store the data DTA, and the local sense amplifier circuit in the third local sense amplifier region LSAB3 may be connected to a third global input/output line pair GIOp3. The local sense amplifier circuit in the third local sense amplifier region LSAB3 may input and output the data DTA stored by the memory cell in the 1_1 sub-memory array SMA11 and the 1_2 sub-memory array SMA12 through the third global input/output line pair GIOp3.

At least a part of a fourth local sense amplifier region LSAB4 may overlap the 1_2 sub-memory array SMA12 in the third direction D3. The local sense amplifier circuit disposed in the fourth local sense amplifier region LSAB4 may be connected to at least a part of the bit lines of the 1_2 sub-memory array SMA12, which is the normal region NR. The memory cell in the normal region NR may store the data DTA, and the local sense amplifier circuit in the fourth local sense amplifier region LSAB4 may be connected to a fourth global input/output line pair GIOp4. The local sense amplifier circuit in the fourth local sense amplifier region LSAB4 may input and output the data DTA stored by the memory cell in the 1_2 sub-memory array SMA12 through the fourth global input/output line pair GIOp4.

At least a part of a fifth local sense amplifier region LSAB5 may overlap the 1_2 sub-memory array SMA12 and the 1_3 sub-memory array SMA13 in the third direction D3. The local sense amplifier circuit disposed in the fifth local sense amplifier region LSAB5 may be connected to at least a part of the bit lines of the 1_2 sub-memory array SMA12, which is the normal region NR, and to at least a part of the bit lines of the 1_3 sub-memory array SMA13. The memory cell in the normal region NR may store the data DTA, and the local sense amplifier circuit in the fifth local sense amplifier region LSAB5 may be connected to a fifth global input/output line pair GIOp5. The local sense amplifier circuit in the fifth local sense amplifier region LSAB5 may input and output the data DTA stored by the memory cell in the 1_2 sub-memory array SMA12 and the 1_3 sub-memory array SMA13 through the fifth global input/output line pair GIOp5.

At least a part of a sixth local sense amplifier region LSAB6 may overlap the 1_3 sub-memory array SMA13 in the third direction D3. The local sense amplifier circuit disposed in the sixth local sense amplifier region LSAB6 may be connected to at least a part of the bit lines of the 1_3 sub-memory array SMA13, which is the normal region NR. The memory cell in the normal region NR may store the data DTA, and the local sense amplifier circuit in the sixth local sense amplifier region LSAB6 may be connected to a sixth global input/output line pair GIOp6. The local sense amplifier circuit in the sixth local sense amplifier region LSAB6 may input and output the data DTA stored by the memory cell in the 1_3 sub-memory array SMA13 through the sixth global input/output line pair GIOp6.

At least a part of a seventh local sense amplifier region LSAB7 may overlap the 1_3 sub-memory array SMA13 and the 1_4 sub-memory array SMA14 in the third direction D3. The local sense amplifier circuit disposed in the seventh local sense amplifier region LSAB7 may be connected to at least a part of the bit lines of the 1_3 sub-memory array SMA13, which is the normal region NR, and to at least a part of the bit lines corresponding to the normal region NR in the 1_4 sub-memory array SMA14. The memory cell in the normal region NR may store the data DTA, and the local sense amplifier circuit in the seventh local sense amplifier region LSAB7 may be connected to a seventh global input/output line pair GIOp7. The local sense amplifier circuit in the seventh local sense amplifier region LSAB7 may input and output the data DTA stored by the memory cell in the 1_3 sub-memory array SMA13 and the 1_4 sub-memory array SMA14 through the seventh global input/output line pair GIOp7.

At least a part of an eighth local sense amplifier region LSAB8 may overlap the 1_4 sub-memory array SMA14 in the third direction D3. The local sense amplifier circuit disposed in the eighth local sense amplifier region LSAB8 may be connected to at least a part of the bit lines of the 1_4 sub-memory array SMA14, which is the normal region NR. The memory cell in the normal region NR may store the data DTA, and the local sense amplifier circuit in the eighth local sense amplifier region LSAB8 may be connected to an eighth global input/output line pair GIOp8. The local sense amplifier circuit in the eighth local sense amplifier region LSAB8 may input and output the data DTA stored by the memory cell in the 1_4 sub-memory array SMA14 through the eighth global input/output line pair GIOp8.

At least a part of a ninth local sense amplifier region LSAB9 may overlap the 1_4 sub-memory array SMA14 and the 1_5 sub-memory array SMA15 in the third direction D3. The local sense amplifier circuit disposed in the ninth local sense amplifier region LSAB9 may be connected to at least a part of the bit lines corresponding to the redundancy region RR in the 1_4 sub-memory array SMA14 and at least a part of the bit lines corresponding to the redundancy region RR in the 1_5 sub-memory array SMA15. The memory cell in the redundancy region RR may store the parity data PRT, and the local sense amplifier circuit in the ninth local sense amplifier region LSAB9 may be connected to a ninth global input/output line pair GIOp9. The local sense amplifier circuit in the ninth local sense amplifier region LSAB9 may input and output the parity data PRT stored by the memory cell in the 1_4 sub-memory array SMA14 and the 1_5 sub-memory array SMA15 through the ninth global input/output line pair GIOp9. As used herein, a memory cell connected to the ninth local sense amplifier region LSAB9 and storing the parity data PRT may be referred to as an "ECC cell". For example, the redundancy region RR may be differentiated from the normal region NR based on bit lines connected thereto.

At least a part of a tenth local sense amplifier region LSAB10 may overlap the 1_5 sub-memory array SMA15 in the third direction D3. The local sense amplifier circuit disposed in the tenth local sense amplifier region LSAB10 may be connected to at least a part of the bit lines of the 1_5 sub-memory array SMA15, which is the normal region NR. The memory cell in the normal region NR may store the data DTA, and the local sense amplifier circuit in the tenth local sense amplifier region LSAB10 may be connected to a tenth global input/output line pair GIOp10. The local sense amplifier circuit in the tenth local sense amplifier region LSAB10 may input and output the data DTA stored by the memory cell in the 1_5 sub-memory array SMA15 through the tenth global input/output line pair GIOp10.

At least a part of an eleventh local sense amplifier region LSAB11 may overlap the 1_5 sub-memory array SMA15 and the 1_6 sub-memory array SMA16 in the third direction D3. The local sense amplifier circuit disposed in the eleventh local sense amplifier region LSAB11 may be connected to at least a part of the bit lines of the 1_5 sub-memory array SMA15, which is the normal region NR, and to at least a part of the bit lines corresponding to the normal region NR in the 1_6 sub-memory array SMA16. The memory cell in the normal region NR may store the data DTA, and the local sense amplifier circuit in the eleventh local sense amplifier region LSAB11 may be connected to an eleventh global input/output line pair GIOp11. The local sense amplifier circuit in the eleventh local sense amplifier region LSAB11 may input and output the data DTA stored by the memory cell in the 1_5 sub-memory array SMA15 and the 1_6 sub-memory array SMA16 through the eleventh global input/output line pair GIOp11.

At least a part of a twelfth local sense amplifier region LSAB12 may overlap the 1_6 sub-memory array SMA16 in the third direction D3. The local sense amplifier circuit disposed in the twelfth local sense amplifier region LSAB12 may be connected to at least a part of the bit lines of the 1_6 sub-memory array SMA16, which is the normal region NR. The memory cell in the normal region NR may store the data DTA, and the local sense amplifier circuit in the twelfth local sense amplifier region LSAB12 may be connected to a twelfth global input/output line pair GIOp12. The local sense amplifier circuit in the twelfth local sense amplifier region LSAB12 may input and output the data DTA stored by the memory cell in the 1_6 sub-memory array SMA16 through the twelfth global input/output line pair GIOp12.

At least a part of a thirteenth local sense amplifier region LSAB13 may overlap the 1_6 sub-memory array SMA16 and the 1_7 sub-memory array SMA17 in the third direction D3. The local sense amplifier circuit disposed in the thirteenth local sense amplifier region LSAB13 may be connected to at least a part of the bit lines of the 1_6 sub-memory array SMA16, which is the normal region NR, and to at least a part of the bit lines of the 1_7 sub-memory array SMA17. The memory cell in the normal region NR may store the data DTA, and the local sense amplifier circuit in the thirteenth local sense amplifier region LSAB13 may be connected to a thirteenth global input/output line pair GIOp13. The local sense amplifier circuit in the thirteenth local sense amplifier region LSAB13 may input and output the data DTA stored by the memory cell in the 1_6 sub-memory array SMA16 and the 1_7 sub-memory array SMA17 through the thirteenth global input/output line pair GIOp13.

At least a part of a fourteenth local sense amplifier region LSAB14 may overlap the 1_7 sub-memory array SMA17 in the third direction D3. The local sense amplifier circuit disposed in the fourteenth local sense amplifier region LSAB14 may be connected to at least a part of the bit lines of the 1_7 sub-memory array SMA17, which is the normal region NR. The memory cell in the normal region NR may store the data DTA, and the local sense amplifier circuit in the fourteenth local sense amplifier region LSAB14 may be connected to a fourteenth global input/output line pair GIOp14. The local sense amplifier circuit in the fourteenth local sense amplifier region LSAB14 may input and output the data DTA stored by the memory cell in the 1_7 sub-memory array SMA17 through the fourteenth global input/output line pair GIOp14.

At least a part of a fifteenth local sense amplifier region LSAB15 may overlap the 1_7 sub-memory array SMA17 and the 1_8 sub-memory array SMA18 in the third direction D3. The local sense amplifier circuit disposed in the fifteenth local sense amplifier region LSAB15 may be connected to at least a part of the bit lines of the 1_7 sub-memory array SMA17, which is the normal region NR, and to at least a part of the bit lines of the 1_8 sub-memory array SMA18. The memory cell in the normal region NR may store the data DTA, and the local sense amplifier circuit in the fifteenth local sense amplifier region LSAB15 may be connected to a fifteenth global input/output line pair GIOp15. The local sense amplifier circuit in the fifteenth local sense amplifier region LSAB15 may input and output the data DTA stored by the memory cell in the 1_7 sub-memory array SMA17 and the 1_8 sub-memory array SMA18 through the fifteenth global input/output line pair GIOp15.

At least a part of a sixteenth local sense amplifier region LSAB16 may overlap the 1_8 sub-memory array SMA18 in the third direction D3. The local sense amplifier circuit disposed in the sixteenth local sense amplifier region LSAB16 may be connected to at least a part of the bit lines of the 1_8 sub-memory array SMA18, which is the normal region NR. The memory cell in the normal region NR may store the data DTA, and the local sense amplifier circuit in the sixteenth local sense amplifier region LSAB16 may be connected to a sixteenth global input/output line pair GIOp16. The local sense amplifier circuit in the sixteenth local sense amplifier region LSAB16 may input and output the data DTA stored by the memory cell in the 1_8 sub-memory array SMA18 through the sixteenth global input/output line pair GIOp16.

At least a part of a seventeenth local sense amplifier region LSAB17 may overlap the 1_8 sub-memory array SMA18 in the third direction D3. The local sense amplifier circuit disposed in the seventeenth local sense amplifier region LSAB17 may be connected to at least a part of the bit lines of the 1_8 sub-memory array SMA18, which is the normal region NR. The memory cell in the normal region NR may store the data DTA, and the local sense amplifier circuit in the seventeenth local sense amplifier region LSAB17 may be connected to a seventeenth global input/output line pair GIOp17. The local sense amplifier circuit in the seventeenth local sense amplifier region LSAB17 may input and output the data DTA stored by the memory cell in the 1_8 sub-memory array SMA18 through the seventeenth global input/output line pair GIOp17.

The first to seventeenth local sense amplifier regions LSAB1 to LSAB17 may be arranged in the second direction D2. The first to seventeenth local sense amplifier regions LSAB 1 to LSAB17 may be disposed above the 1_1 to 1_8 sub-memory arrays SMA11 to SMA18 based on the first direction D1.

The first to eighth local sense amplifier regions LSAB1 to LSAB8 and the tenth to seventeenth local sense amplifier regions LSAB10 to LSAB17 may correspond to the normal region NR in the first row block RB1, and the ninth local sense amplifier region LSAB9 may correspond to the redundancy region RR in the first row block RB 1. The normal region NR and the redundancy region RR may be divided based on the bit lines included in the first row block RB1.

The first row block RB1 may allocate a region corresponding to a specific local sense amplifier circuit as the redundancy region RR through the arrangement of the 1_1 to 1_8 sub-memory arrays SMA11 to SMA18 and the first to seventeenth local sense amplifier regions LSAB1 to LSAB17, without arrangement of sub-memory arrays for ECC cells or redundancy cells. The arrangement of the first row block RB1 as described above may reduce the sub-word driver region (e.g., may reduce an area of the sub-word line driver region) disposed on the first bank array 210a and improve the area efficiency of the configurations within the memory device 10.

Although not shown in FIG. 6, the memory device 10 may include a local sense amplifier region disposed on the lower side of the 1_1 to 1_8 sub-memory arrays SMA11 to SMA18 in the first direction D1, in addition to the first to seventeenth local sense amplifier regions LSAB1 to LSAB17 on the upper side.

Although not shown in FIG. 6, at least a part of the first to seventeenth local sense amplifier regions LSAB1 to LSAB17 may overlap 2_1 to 2_8 sub-memory arrays SMA21 to SMA28 in the third direction D3. The local sense amplifier circuits disposed in the first to seventeenth local sense amplifier regions LSAB1 to LSAB17 may be connected to the bit lines of the 2_1 to 2_8 sub-memory arrays SMA21 to SMA28.

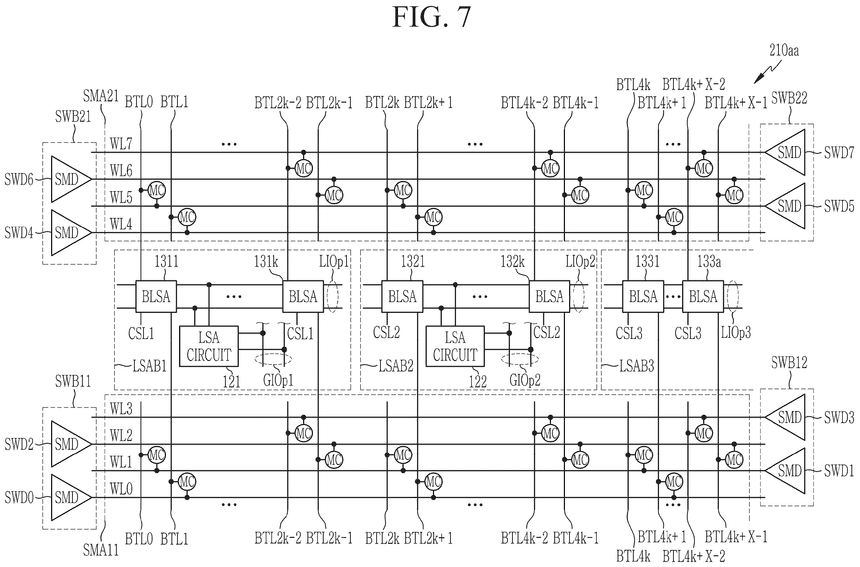

FIG. 7 is a circuit diagram illustrating a part of a first bank array of FIG. 5 in detail. Specifically, FIG. 7 shows the connection relationship of components arranged in the 1_1 sub-memory array SMA11, the 2_1 sub-memory array SMA21, the first to third local sense amplifier regions LSAB1 to LSAB3, the 1_1 and 1_2 sub-word line driver regions SWB11 and SWB 12, and 2_1 and 2_2 sub-word line driver regions SWB21 and SWB22.

Referring to FIGS. 5 to 7, the 1_1 sub-memory array SMA11 and the 2_1 sub-memory array SMA21 may be disposed in a part 210aa of the first bank array 210a. Although not specifically shown in FIG. 7, the first to third local sense amplifier regions LSAB 1 to LSAB3, the 1_1 and 1_2 sub-word line driver regions SWB 11 and SWB12, and the 2_1 and 2_2 sub-word line driver regions SWB21 and SWB22 may be included in a peripheral circuit region PS (100) of the memory device 10 (e.g., see FIGS. 2 and 4).

The 1_1 sub-memory array SMA11 may include zeroth to third word lines WL0 to WL3 extending in the second direction D2, zeroth to 4k+X-1 bit lines BTLO to BTL4k+X-1 extending in the first direction D1, and a plurality of memory cells MC disposed at the intersection of the zeroth to third word lines WL0 to WL3 and the zeroth to 4k+X-1 bit lines BTLO to BTL4k+X-1. While memory cells are not shown in FIG. 7 at some of the points where the word lines and the bit lines intersect, the present disclosure is not limited thereto, and memory cells MC may be disposed at all of the points where the word lines and the bit lines intersect. Depending on the embodiments, k may be 256 and X may be 64.

The 2_1 sub-memory array SMA21 may include fourth to seventh word lines WL4 to WL7 extending in the second direction D2, the zeroth to 4k+X-1 bit lines BTLO to BTL4k+X-1 extending in the first direction D1, and a plurality of memory cells MC disposed at the intersection of the fourth to seventh word lines WL4 to WL7 and the zeroth to 4k+X-1 bit lines BTLO to BTL4k+X-1. Although the sub-memory arrays SMA11 and SMA21 are shown in FIG. 7 as including four word lines, the number of word lines is only an example, and the present disclosure is not limited thereto.

Depending on the embodiments, the plurality of sub-memory arrays SMA11 to SMA88 in the first bank array 210a may include the same number of bit lines as the number of bit lines included in the 1_1 and 2_1 sub-memory arrays SMA11 and SMA21. Depending on the embodiments, the plurality of sub-memory arrays SMA11 to SMA88 of the first bank array 210a may include 4k+X bit lines.

The 1_1 sub-word line driver region SWB11 may include a zeroth sub-word line driver SWD0 that applies a driving voltage to the zeroth word line WL0 and a second sub-word line driver SWD2 that applies a driving voltage to the second word line WL2. The 1_2 sub-word line driver region SWB12 may include a first sub-word line driver SWD1 that applies a driving voltage to the first word line WL1 and a third sub-word line driver SWD3 that applies a driving voltage to the third word line WL3.

The 2_1 sub-word line driver region SWB21 may include a fourth sub-word line driver SWD4 that applies a driving voltage to the fourth word line WL4 and a sixth sub-word line driver SWD6 that applies a driving voltage to the sixth word line WL6. The 2_2 sub-word line driver region SWB22 may include a fifth sub-word line driver SWD5 that applies a driving voltage to the fifth word line WL5 and a seventh sub-word line driver SWD7 that applies a driving voltage to the seventh word line WL7.

Although not specifically shown, similar to the arrangement between the 1_1 to 1_8 sub-memory arrays SMA11 to SMA18 and the 1_1 to 1_9 sub-word line driver regions SWB11 to SWB19 in FIG. 6, at least a part of the 2_1 sub-word line driver region SWB21 and at least a part of the 2_2 sub-word line driver region SWB22 may overlap the 2_1 sub-memory array SMA21 in the third direction D3.

The first local sense amplifier region LSAB1 may include a first local sense amplifier circuit 121 and 1_1 to 1_k bit line sense amplifiers 1311 to 131k.

Depending on the embodiments, the 1_1 to 1_k bit line sense amplifiers 1311 to 131k may be connected to zeroth to 2k-1 bit lines BTLO to BTL2k-1 of the 1_1 and 2_1 sub-memory arrays SMA11 and SMA21 in an open bit line structure. For example, the 1_1 bit line sense amplifier 1311 may be connected to the first bit line BTL1 of the 1_1 sub-memory array SMA11 and the zeroth bit line BTLO of the 2_1 sub-memory array SMA21. The 1_k bit line sense amplifier 131k may be connected to the 2k-1 bit line BTL2k-1 of the 1_1 sub-memory array SMA11 and a 2k-2 bit line BTL2k-2 of the 2_1 sub-memory array SMA21. The connection method of the zeroth to 2k-1 bit lines BTLO to BTL2k-1 and the 1_1 to 1_k bit line sense amplifiers 1311 to 131k is not limited to the open bit line structure, and the connection method may be a folded bit line structure, or a mixture of the folded bit line structure and the open bit line structure depending on the embodiments.

The first local sense amplifier circuit 121 and the 1_1 to 1_k bit line sense amplifiers 1311 to 131k may be connected through a first local input/output line pair LIOp1. The first local sense amplifier circuit 121 may be connected to the zeroth to 2k-1 bit lines BTLO to BTL2k-1 through the 1_1 to 1_k bit line sense amplifiers 1311 to 131k and the first local input/output line pair LIOp1. The 1_1 to 1_k bit line sense amplifiers 1311 to 131k may receive a first column selection signal CSL1 from the first column decoder 150a of FIG. 2, and based on the first column selection signal CSL1, one of the 1_1 to 1_k bit line sense amplifiers 1311 to 131k and the first local sense amplifier circuit 121 may be connected through the first local input/output line pair LIOp1. The connected bit line sense amplifier may amplify the difference in voltage levels detected between the bit lines and provide the amplified voltage level difference to the first local sense amplifier circuit 121.

The first local sense amplifier circuit 121 may be activated in response to a control signal, and when the first local sense amplifier circuit 121 is activated, the voltage difference between the first local input/output line pair LIOp1 may be amplified and provided to the first global input/output line pair GIOp1.

The second local sense amplifier region LSAB2 may include a second local sense amplifier circuit 122 and 2_1 to 2_k bit line sense amplifiers 1321 to 132k.

Depending on the embodiments, the 1_2 to 2_k bit line sense amplifiers 1321 to 132k may be connected to 2k to 4k-1 bit lines BTL2k to BTL4k-1 of the 1_1 and 2_1 sub-memory arrays SMA11 and SMA21 in an open bit line structure.

The second local sense amplifier circuit 122 and the 2_1 to 2_k bit line sense amplifiers 1321 to 132k may be connected through a second local input/output line pair LIOp2. The second local sense amplifier circuit 122 may be connected to the 2k to 4k-1 bit lines BTL2k to BTL4k-1 through the 2_1 to 2_k bit line sense amplifiers 1321 to 132k and the second local input/output line pair LIOp2. The 2_1 to 2_k bit line sense amplifiers 1321 to 132k may receive a second column selection signal CSL2 from the first column decoder 150a of FIG. 2, and based on the second column selection signal CSL2, one of the 2_1 to 2_k bit line sense amplifiers 1321 to 132k and the second local sense amplifier circuit 122 may be connected through the second local input/output line pair LIOp2. The connected bit line sense amplifier may amplify the difference in voltage levels detected between the bit lines and provide the amplified voltage level difference to the second local sense amplifier circuit 122.

The second local sense amplifier circuit 122 may be activated in response to a control signal, and when the second local sense amplifier circuit 122 is activated, the voltage difference between the second local input/output line pair LIOp2 may be amplified and provided to the second global input/output line pair GIOp2.

The third local sense amplifier region LSAB3, like the first and second local sense amplifier regions LSAB1 and LSAB2, may include a local sense amplifier circuit and k bit line sense amplifiers. The k bit line sense amplifiers included in the third local sense amplifier region LSAB3 may include 3_1 to 3_a bit line sense amplifiers 1331 to 133a connected to 4k to 4k+X-1 bit lines BTL4k to BTL4k+X-1 of the 1_1 and 2_1 sub-memory arrays SMA11 and SMA21. Depending on the embodiments, the 'a' may be 32.

Depending on the embodiments, the 3_1 to 3_a bit line sense amplifiers 1331 to 133a may be connected to the 4k to 4k+X-1 bit lines BTL4k to BTL4k+X-1 of the 1_1 and 2_1 sub-memory arrays SMA11 and SMA21 in an open bit line structure. Although not shown, the bit line sense amplifier included in the third local sense amplifier region LSAB3 other than the 3_1 to 3_a bit line sense amplifiers 1331 to 133a may be connected to the bit line of the 1_2 and 2_2 sub-memory arrays SMA12 and SMA22 in an open bit line structure.

The k bit line sense amplifiers in the third local sense amplifier region LSAB3 may receive a third column selection signal CSL3 from the first column decoder 150a of FIG. 2, and based on the third column selection signal CSL3, one of the k bit line sense amplifiers and the local sense amplifier circuit may be connected through the third local input/output line pair LIOp3. The connected bit line sense amplifier may amplify the difference in voltage levels detected between the bit lines and provide the amplified voltage level difference to the local sense amplifier circuit.

The local sense amplifier circuit in the third local sense amplifier region LSAB3 may be activated in response to a control signal, and when the local sense amplifier circuit is activated, the voltage difference between the third local input/output line pair LIOp3 may be amplified and provided to the third global input/output line pair (GIOp3).

Depending on the embodiments, the first to seventeenth local sense amplifier regions LSAB1 to LSAB17 connected to the first row block RB1 may include k bit line sense amplifiers, like the first to second local sense amplifier regions LSAB1 and LSAB2. Accordingly, each of the local sense amplifier circuits included in the first to seventeenth local sense amplifier regions LSAB1 to LSAB17 may be connected to 2k bit lines.

Depending on the embodiments, the ratio of the number of 2k bit lines connected to the local sense amplifier circuit in each of the first to seventeenth local sense amplifier regions LSAB1 to LSAB17 to the number of 4k+X bit lines included in each of the plurality of sub-memory arrays SMA11 to SMA88 may be 1 to x1.

The x1 may be a rational number rather than an integer greater than 2. For example, x1 may be a rational number that is not a whole number greater than 2 (e.g., x1 is not 3, 4, 5, etc.). Depending on the embodiments, the x1 may be within 2.05 to 2.35, and preferably within 2.1 to 2.3. In other words, x1 may be in a range from 2.05 to 2.35 (e.g., a range from 2.1 to 2.3).

With the ratio of the number of bit lines connected to the local sense amplifier circuit to the number of bit lines included in the sub-memory arrays and the connections of the bit lines described above, the 1_1 to 1_8 sub-memory arrays SMA11 to SMA18 of the first row block RB1 and the first to seventeenth local sense amplifier regions LSAB1 to LSAB17 may be arranged and connected as shown in FIG. 6.

With the arrangement of the 1_1 to 1_8 sub-memory arrays SMA11 to SMA18 and the first to seventeenth local sense amplifier regions LSAB1 to LSAB17 as shown in FIG. 6, the first row block RB1 may allocate a region corresponding to a specific local sense amplifier circuit as a redundancy region RR without separately arranging sub-memory arrays for ECC cells or redundancy cells.

The bit line connection relationship described above may reduce the sub-word driver region disposed on the first bank array 210a (e.g., may reduce an area of the sub-word line driver region) and improve the area efficiency of the configurations within the memory device.

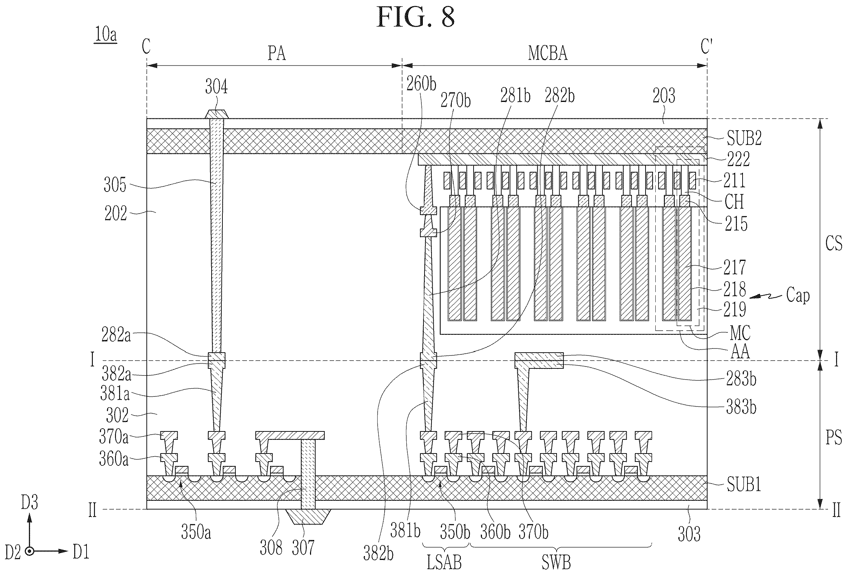

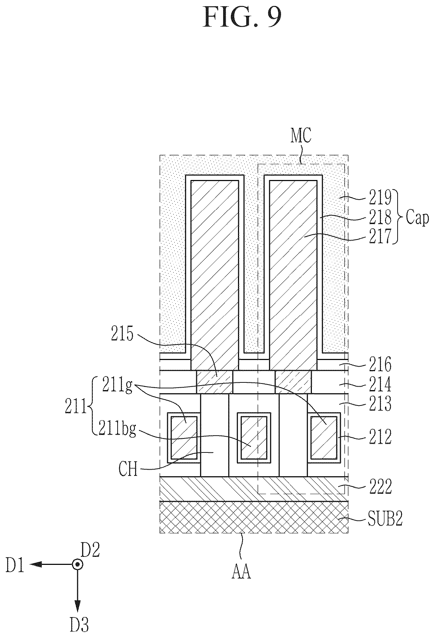

FIG. 8 is a cross-sectional view taken along line C-C' of the memory device of FIG. 4. FIG. 9 is an enlarged view of the region AA of FIG. 8.

Referring to FIGS. 2, 4 to 6, 8, and 9, a memory device 10a according to some embodiments may have a chip to chip (C2C) structure. The C2C structure may be fabricated by forming on a first wafer an upper chip including the memory cell region CS; forming, on a second wafer different from the first wafer, a lower chip including the peripheral circuit region PS; and then using a bonding method to connect the upper and lower chips to each other. For example, the bonding method may include electrically connecting a bonding metal formed on an uppermost metal layer of the upper chip to a bonding metal formed on an uppermost metal layer of the lower chip. For example, when the bonding metal is formed of copper (Cu), the bonding method may be a Cu-Cu bonding method, and the bonding metal may also be formed of aluminum or tungsten.

Each of the peripheral circuit region PS and the memory cell region CS of the semiconductor memory device 10a according to some embodiments may include an external pad bonding area PA and a memory cell bonding area MCBA.

The peripheral circuit region PS may include a first substrate SUB1, a first interlayer insulating layer 302, a plurality of circuit elements 350a and 350b disposed on the first substrate SUB1, first metal layers 360a and 360b connected to each of the plurality of circuit elements 350a and 350b, and second metal layers 370a and 370b disposed on the first metal layers 360a and 360b. In some embodiments, the first metal layers 360a and 360b may be formed of tungsten, which has a relatively high resistance, and the second metal layers 370a and 370b may be formed of copper, which has a relatively low resistance.

In FIG. 8, only the first metal layers 360a and 360b and the second metal layers 370a and 370b are shown, but the present disclosure is not limited thereto and at least one more metal layer may be further disposed on the second metal layers 370a and 370b. At least some of the one or more metal layers disposed on the upper portion of the second metal layers 370a and 370b may be aluminum, which has lower resistance than copper on which the second metal layers 370a and 370b are disposed.

The first interlayer insulating layer 302 is disposed on the first substrate SUB1 to cover the plurality of circuit elements 350a and 350b, the first metal layers 360a and 360b, and the second metal layers 370a and 370b, and may include an insulating material such as a silicon oxide, a silicon nitride, or the like.

The memory cell region CS may include a plurality of memory cells MC. The memory cell region CS may include a second substrate SUB2, bit lines 222, a first metal layer 260b connected to each of the bit lines 222, and a second metal layer 270b disposed on the first metal layer 260b. In some embodiments, the first metal layer 260a may be formed of tungsten, which has relatively high resistance, and the second metal layer 270b may be formed of copper, which has relatively low resistance. Each of the plurality of memory cells MC and bit lines 222 may correspond to the memory cells MC and bit lines BTL in FIGS. 2 to 7.

In some embodiments, a region where the plurality of memory cells MC and bit lines 222, etc. are disposed may be defined as the memory cell bonding area MCBA. Referring to FIGS. 8 and 9, in the memory cell bonding area MCBA, the memory cell region CS may include the bit line 222, a memory vertical channel layer CH, a plurality of first gate electrodes 211, a first gate insulating layer 212, and a capacitor structure Cap.

Depending on the embodiments, the plurality of memory cells MC may include a vertical channel transistor (VCT). The vertical channel transistor may refer to a structure in which the memory vertical channel layer CH extends along the third direction D3, which is a vertical direction from the second substrate SUB2. For example, the third direction D3 may be perpendicular to an upper surface of the first substrate SUB1. The third direction D3 is perpendicular (e.g., orthogonal) to the first direction D1 in which the bit line 222 extends and the second direction D2 in which the first gate electrode 211 extends.

The bit line 222 may be arranged to extend parallel to the lower surface of the second substrate SUB2. Although not shown in FIGS. 8 and 9, the plurality of bit lines 222 may be arranged in the memory cell region CS, and an insulating pattern may be arranged in the spaces between the plurality of bit lines 222. The insulating pattern may extend in the first direction D1, and the upper surface of the insulating pattern may be disposed at the same height as the upper surface of the bit line 222.

For example, the bit line 222 may include doped polysilicon, a metal, a conductive metal nitride, a conductive metal silicide, a conductive metal oxide, or a combination thereof. For example, the bit line 222 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto. The bit line 222 may include a single layer or multiple layers of the materials described above. Depending on the embodiments, the bit line 222 may include a two-dimensional semiconductor material, for example, the two-dimensional semiconductor material may include graphene, carbon nanotubes, or a combination thereof.

The memory vertical channel layers CH may be arranged to be spaced apart from each other in the first direction D1 on the bit line 222. Although not shown, the memory vertical channel layers CH may be arranged in a matrix form on a plurality of bit lines to be spaced apart from each other in the first direction D1 and the second direction D2. The bottom part of the memory vertical channel layer CH may function as a first source/drain region (not shown), and the upper portion of the memory vertical channel layer CH may function as a second source/drain region (not shown). A part of the memory vertical channel layer CH between the first and second source/drain regions may function as a channel region (not shown).

For example, the memory vertical channel layer CH may include silicon, an oxide semiconductor, or a combination thereof. For example, the oxide semiconductor may include InₓGa_{y}Zn_{z}O (IGZO), InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or a combination thereof. In some embodiments, the vertical channel layer CH may include at least one of silicon or indium gallium zinc oxide (IGZO).

The memory vertical channel layer CH may include a single layer or multiple layers of the oxide semiconductor. In some examples, the memory vertical channel layer CH may have bandgap energy that is greater than that of silicon. For example, the memory vertical channel layer CH may have band gap energy of about 1.5 eV to 5.6 eV. For example, the memory vertical channel layer CH may have optimal channel performance when the memory vertical channel layer CH has bandgap energy of about 2.0 eV to 4.0 eV. For example, the memory vertical channel layer CH may be polycrystalline or amorphous, but is not limited thereto. In example embodiments, the memory vertical channel layer CH may include a two-dimensional semiconductor material, for example, graphene, carbon nanotubes, or a combination thereof.

The first gate electrode 211 may extend in the second direction D2 on both (i.e., opposing) sidewalls of the memory vertical channel layer CH. The first gate electrode 211 may include a first sub-gate electrode 211g facing a first sidewall of the memory vertical channel layer CH, and a first back gate electrode 211bg facing a second sidewall, which is opposing the first sidewall of the memory vertical channel layer CH. The first sub-gate electrode 211g may function as one of the plurality of word lines WL of FIGS. 2 to 7, and the first back gate electrode 211bg may perform the function of forming the bottom potential of the vertical channel transistor including the memory vertical channel layer CH.

The first gate electrode 211 may include doped polysilicon, a metal, a conductive metal nitride, a conductive metal silicide, a conductive metal oxide, or a combination thereof. For example, the first gate electrode 211 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof, but is not limited thereto.

The first gate insulating layer 212 may be disposed surrounding the first gate electrode 211, and at least a part of the first gate insulating layer 212 may be disposed between the first gate electrode 211 and the memory vertical channel layer CH. In FIG. 9, the first gate insulating layer 212 is disposed to surround the first gate electrode 211, but depending on the embodiments, the first gate insulating layer 212 may have a shape disposed along at least a part of the side wall of the first gate insulating layer 212.

In example embodiments, the first gate insulating layer 212 may be made of a silicon oxide layer, a silicon oxynitride layer, a high-k dielectric layer having a higher dielectric constant than that of a silicon oxide layer, or a combination thereof. The high-k dielectric layer may be made of a metal oxide or a metal oxynitride. For example, the high-k dielectric layer usable as the first gate insulating layer 212 may be made of HfO₂, HfSiO, HfSiON, HfTaO, HfTiO, HfZrO, ZrO₂, Al₂O₃, or a combination thereof, but is not limited thereto.

A first interlayer insulating layer 213 may be disposed in the space between the first gate electrode 211 on the bit line 222 and the memory vertical channel layer CH. In FIG. 9, the first interlayer insulating layer 213 is shown as one continuous material layer, but depending on the embodiments, the first interlayer insulating layer 213 may be arranged in a plurality of insulating patterns.

A capacitor contact 215 may be arranged on the memory vertical channel layer CH. The capacitor contact 215 may be arranged to vertically overlap the memory vertical channel layer CH in the third direction D3. The capacitor contact 215 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof, but is not limited thereto. A first upper insulating layer 214 may surround the sidewall of the capacitor contact 215 on the first interlayer insulating layer 213.

A first etch stop layer 216 may be disposed on the first upper insulating layer 214, and the capacitor structure Cap may be disposed on the first etch stop layer 216. The capacitor structure Cap may include a lower electrode 217, a capacitor dielectric layer 218, and an upper electrode 219.

The lower electrode 217 may penetrate (i.e., extend into) the first etch stop layer 216 and be electrically connected to the upper surface of the capacitor contact 215. The lower electrode 217 may be arranged in a pillar type extending in the third direction D3, but is not limited thereto. In example embodiments, the lower electrode 217 may be arranged to overlap the capacitor contact 215 on a plane along the third direction D3. Alternatively, a landing pad (not shown) may be further disposed between the capacitor contact 215 and the lower electrode 217, so that the lower electrode 217 may be arranged in a hexagonal shape.

The first gate electrode 211, the memory vertical channel layer CH, and the capacitor structure Cap may function as one memory cell MC. The first gate electrode 211 and the memory vertical channel layer CH may function as a transistor, and the capacitor structure Cap may function as a capacitor. The memory cell MC may correspond to one of the plurality of memory cells MC shown in FIGS. 2 to 7.

In the memory cell bonding area MCBA, the plurality of memory cells MC may be electrically connected to the first metal layer 260b and the second metal layer 270b. For example, the first metal layer 260b may be a bit line contact.

Lower bonding metals 381b and 382b may be disposed on the second metal layer 370b of the memory cell bonding area MCBA. In the memory cell bonding area MCBA, the lower bonding metals 381b and 382b of the peripheral circuit region PS may be electrically connected to the upper bonding metals 281b and 282b of the memory cell region CS by a bonding method. The lower bonding metals 381b and 382b and the upper bonding metals 281b and 282b may be aluminum, copper, or tungsten.

In the memory cell bonding area MCBA, the bit line 222 may be electrically connected to circuit elements 350b that provide components disposed in a local sense amplifier region LSAB of the peripheral circuit region PS. For example, the bit line 222 may be connected to the upper bonding metals 281b and 282b in the memory cell region CS, and the upper bonding metals 281b and 282b may be connected to the lower bonding metals 381b and 382b connected to the circuit elements 350b disposed in the local sense amplifier region LSAB. Components disposed in the local sense amplifier region LSAB may overlap the plurality of memory cells MC and the bit line 222 on a plane in the third direction D3. The local sense amplifier region LSAB may correspond to the first to seventeenth local sense amplifier regions LSAB1 to LSAB17.

In the memory cell bonding area MCBA, the first gate electrode 211 may be electrically connected to the circuit elements 350b that provide components disposed in a sub-word line driver region SWB of the peripheral circuit region PS. Although not shown, the first gate electrode 211 may be connected to the upper bonding metals 281b and 282b in the memory cell region CS, and the upper bonding metals 281b and 282b may be connected to the lower bonding metals 381b and 382b connected to the circuit elements 350b disposed in the sub-word line driver region SWB. Depending on the embodiments, the first gate electrode 211 may be electrically connected to the circuit elements 350b disposed in the sub-word line driver region SWB through a lower metal pattern 383b disposed on the uppermost metal layer of the peripheral circuit region PS and an upper metal pattern 283b disposed on the uppermost metal layer of the memory cell region CS. Depending on the embodiments, a contact may not be disposed on the upper metal pattern 283b disposed on the uppermost metal layer of the memory cell region CS. The sub-word line driver region SWB may correspond to the 1_1 to 1_9 sub-word line driver regions SWB11 to SWB19.

Meanwhile, the external pad bonding area PA may include a first external pad 307 disposed on the peripheral circuit region PS and a second external pad 304 disposed on the memory cell region CS. For example, the second external pad 304 may be located on an upper surface of the memory cell region CS. Referring to FIG. 8, a lower insulating layer 303 may be disposed on the lower portion of the first substrate SUB 1 to cover the lower surface of the first substrate SUB1, and the first external pad 307 may be disposed on a lower insulating layer 303. The first external pad 307 is connected to at least one of the plurality of circuit elements 350a or 350b disposed in the peripheral circuit region PS through a first external contact plug 308, and may be separated from the first substrate SUB1 by the lower insulating layer 303. Although not shown, a side insulating layer is disposed between the first external contact plug 308 and the first substrate SUB1 to electrically separate the first external contact plug 308 from the first substrate SUB1.

An upper insulating layer 203 covering the upper surface of the second substrate SUB2 may be disposed on the second substrate SUB2, and a second external pad 304 may be disposed on the upper insulating layer 203. The second external pad 304 may be electrically connected to at least one of the plurality of circuit elements 350a or 350b disposed in the peripheral circuit region PS through the second external contact plug 305 extending in the third direction D3 and penetrating a second interlayer insulating layer 202 of the memory cell region CS. For example, the second external contact plug 305 may extend in the memory cell region CS. The second external pad 304 may be separated from the second substrate SUB2 by the upper insulating layer 203. The second external contact plug 305 is connected to an upper bonding metal 282a, and the upper bonding metal 282a may be connected in a bonding form to lower bonding metals 381a and 382a connected to the circuit elements 350a of the peripheral circuit region PS. The lower bonding metals 381a and 382a and the upper bonding metal 282a may be formed of aluminum, copper, or tungsten.

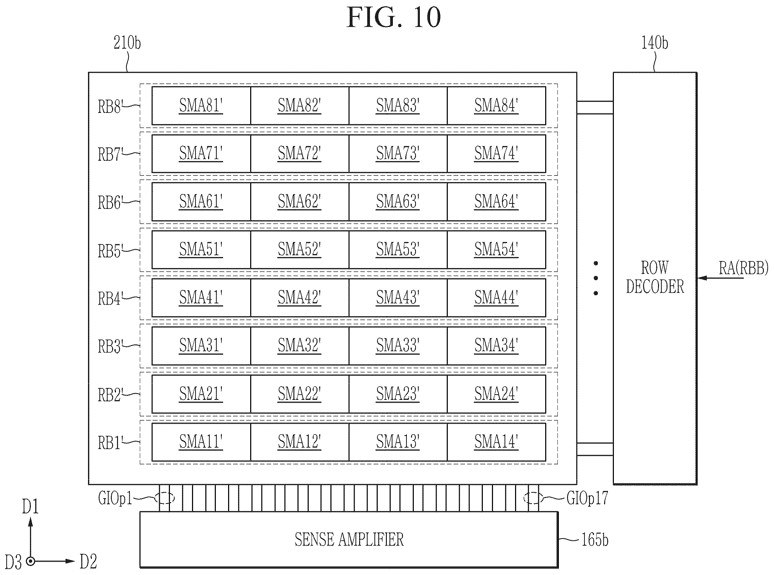

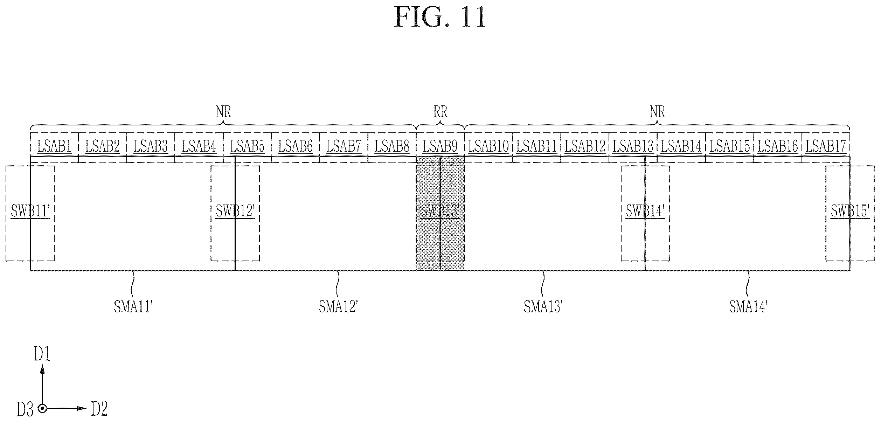

FIG. 10 is a top plan view for describing a bank array according to some further embodiments. FIG. 11 is a top plan view for describing the first row block of FIG. 10. A second bank array 210b, first to eighth row blocks RB1' to RB8', and first to seventeenth local sense amplifier regions LSAB1 to LSAB17 may respectively correspond to the first bank array 210a, the first to eighth row blocks RB1 to RB8, and the first to seventeenth local sense amplifier regions LSAB1 to LSAB17 of FIGS. 5 and 6. For ease of description below, the second bank array 210b, the first to eighth row blocks RB1' to RB8', and the first to seventeenth local sense amplifier regions LSAB1 to LSAB17 will be described, focusing on the differences from the first bank array 210a, the first to eighth row blocks RB1 to RB8, and the first to seventeenth local sense amplifier regions LSAB1 to LSAB17 of FIGS. 5 and 6.

Referring to FIGS. 2, 3, 10, and 11, the components and arrangement of the components within the memory device 10 will be described below based on the second bank array 210b. It will be understood that the description of the second bank array 210b may be applied in the same or similar manner to the rest of the bank arrays 210a to 210s.

The second bank array 210b may include a plurality of sub-memory arrays SMA11' to SMA84'. The plurality of sub-memory arrays SMA11' to SMA84' may be connected to a second row decoder 140b and a second sense amplifier 165b. The second row decoder 140b may include a plurality of sub-word line drivers, and among the plurality of sub-word line drivers, a sub-word line driver corresponding to the row address RA may be activated. The activated sub-word line driver may provide a driving voltage to the word line corresponding to the row address RA.

The second sense amplifier 165b may be connected to the plurality of sub-memory arrays SMA11' to SMA84' through the first to seventeenth global input/output line pairs GIOp1 to GIOp17. Depending on the embodiments, any one of the first to seventeenth global input/output line pairs GIOp1 to GIOp17 connected to the second sense amplifier 165b may be connected to local sense amplifier circuits arranged in the second direction D2. For example, among the local sense amplifier circuits connected to 1_1 to 8_1 sub-memory arrays SMA11' to SMA81', some of the local sense amplifier circuits arranged in the first direction D1 may be connected to the second sense amplifier 165b through the first global input/output line pair GIOp1.

In FIG. 10, the second sense amplifier 165b and the second row decoder 140b are shown as arranged to non-overlap on a plane with the second bank array 210b, but the arrangement of the second sense amplifier 165b and the second row decoder 140b shown in FIG. 10 is for describing the connection relationship with the components. Depending on the embodiments, at least a part of the second sense amplifier 165b and at least a part of the second row decoder 140b may overlap the second bank array 210b in the third direction D3.

The plurality of sub-memory arrays SMA11' to SMA84' may be divided into the first to eighth row blocks RB1' to RB8' arranged in the first direction D1 by the row block identification bits RBB, which are some bits of the row address RA. For example, by the row block identification bit RBB, which is the upper 3 bits of the row address RA, the plurality of sub-memory arrays SMA11' to SMA84' may be divided into the first to eighth row blocks RB1' to RB8' arranged in the first direction D1. Although the second bank array 210b of FIG. 10 includes a plurality of sub-memory arrays arranged in 8 row blocks and 8 column blocks, the present disclosure is not limited thereto, and the number of row blocks and column blocks included in the bank array may vary depending on the embodiments.

The first row block RB1' may include 1_1 to 1_4 sub-memory arrays SMA11' to SMA14' that are divided into the same row block by the row block identification bit RBB. The 1_1 to 1_4 sub-memory arrays SMA11' to SMA14' may be arranged in the second direction D2. Hereinafter, the components and arrangement of the components within the second bank array 210b will be described based on the first row block RB1'. It will be understood that the description of the first row block RB1' may be applied in the same or similar manner to the rest of the row blocks RB1' to RB8'.

Each of the 1_1 to 1_4 sub-memory arrays SMA11' to SMA14' may include a plurality of word lines extending in the second direction D2, a plurality of bit lines extending in the first direction D1, and memory cells connected to the plurality of word lines and the plurality of bit lines.

Depending on the embodiments, the 1_1 to 1_4 sub-memory arrays SMA11' to SMA14' may include a predetermined first number of word lines, and a predetermined second number of bit lines that intersect one word line. Each of the 1_1 to 1_4 sub-memory arrays SMA11' to SMA14' may include the same number of word lines and the same number of bit lines. The number of memory cells connected to one word line in the 1_1 to 1_4 sub-memory arrays SMA11' to SMA14' is the same. For example, the number of memory cells connected to one word line of the 1_1 sub-memory array SMA11' is equal to the number of memory cells connected to one word line of a 1_2 sub-memory array SMA12'.

Referring to FIG. 11, the 1_1 sub-memory array SMA11' may be arranged to overlap at least a part of a 1_1 sub-word line driver region SWB11' and at least a part of a 1_2 sub-word line driver region SWB12' in the third direction D3. Depending on the embodiments, the 1_1 sub-memory array SMA11' may include word lines connected to at least a part of the sub-word line driver disposed in the 1_1 sub-word line driver region SWB11' and to at least a part of the sub-word line driver disposed in the 1_2 sub-word line driver region SWB12'.

The 1_2 sub-memory array SMA12' may be arranged to overlap at least a part of the 1_2 sub-word line driver region SWB12' and at least a part of a 1_3 sub-word line driver region SWB13' in the third direction D3. Depending on the embodiments, the 1_2 sub-memory array SMA12' may include word lines connected to at least a part of the sub-word line driver disposed in the 1_2 sub-word line driver region SWB12' and to at least a part of the sub-word line driver disposed in the 1_3 sub-word line driver region SWB13'.

A 1_3 sub-memory array SMA13' may be arranged to overlap at least a part of the 1_3 sub-word line driver region SWB13' and at least a part of a 1_4 sub-word line driver region SWB14' in the third direction D3. Depending on the embodiments, the 1_3 sub-memory array SMA13' may include word lines connected to at least a part of the sub-word line driver disposed in the 1_3 sub-word line driver region SWB13' and to at least a part of the sub-word line driver disposed in the 1_4 sub-word line driver region SWB14'.

A 1_4 sub-memory array SMA14' may be arranged to overlap at least a part of the 1_4 sub-word line driver region SWB14' and at least a part of a 1_5 sub-word line driver region SWB15' in the third direction D3. Depending on the embodiments, the 1_4 sub-memory array SMA14' may include word lines connected to at least a part of the sub-word line driver disposed in the 1_4 sub-word line driver region SWB14' and to at least a part of the sub-word line driver disposed in the 1_5 sub-word line driver region SWB15'.

The 1_1 to 1_5 sub-word line driver regions SWB11' to SWB15' may be arranged at the boundary between the 1_1 to 1_4 sub-memory arrays SMA11' to SMA14' or on one side of the first row block RB1'. The 1_1 to 1_5 sub-word line driver regions SWB11' to SWB15' may be arranged in the second direction D2.

Depending on the embodiments, the local sense amplifier circuits included in each of first to seventeenth local sense amplifier regions LSAB1 to LSAB17 may be connected to a predetermined third number of bit lines. The circuit disposed in each of the first to seventeenth local sense amplifier regions LSAB1 to LSAB17 operates as a single local sense amplifier circuit, amplifying the difference in voltage levels detected in a plurality of bit line pairs and providing the difference to a pair of global input/output lines. Each of the local sense amplifier circuits in the first to seventeenth local sense amplifier regions LSAB 1 to LSAB 17 is connected to the same number of bit lines, and the local sense amplifier circuit may receive differences in amplified voltage levels from some of the bit lines based on a column selection signal.

At least a part of the first local sense amplifier region LSAB1 may overlap the 1_1 sub-memory array SMA11' in the third direction D3. The local sense amplifier circuit disposed in the first local sense amplifier region LSAB1 may be connected to at least a part of the bit lines of the 1_1 sub-memory array SMA11', which is the normal region NR. The memory cell in the normal region NR may store the data DTA, and the local sense amplifier circuit in the first local sense amplifier region LSAB1 may be connected to the first global input/output line pair GIOp1. The local sense amplifier circuit in the first local sense amplifier region LSAB1 may input and output the data DTA stored by the memory cell in the 1_1 sub-memory array SMA11' through the first global input/output line pair GIOp1.

At least a part of the second local sense amplifier region LSAB2 may overlap the 1_1 sub-memory array SMA11' in the third direction D3. The local sense amplifier circuit disposed in the second local sense amplifier region LSAB2 may be connected to at least a part of the bit lines of the 1_1 sub-memory array SMA11', which is the normal region NR. The memory cell in the normal region NR may store the data DTA, and the local sense amplifier circuit in the second local sense amplifier region LSAB2 may be connected to the second global input/output line pair GIOp2. The local sense amplifier circuit in the second local sense amplifier region LSAB2 may input and output the data DTA stored by the memory cell in the 1_1 sub-memory array SMA11' through the second global input/output line pair GIOp2.

At least a part of a third local sense amplifier region LSAB3 may overlap the 1_1 sub-memory array SMA11' in the third direction D3. The local sense amplifier circuit disposed in the third local sense amplifier region LSAB3 may be connected to at least a part of the bit lines of the 1_1 sub-memory array SMA11', which is the normal region NR. The memory cell in the normal region NR may store the data DTA, and the local sense amplifier circuit in the third local sense amplifier region LSAB3 may be connected to a third global input/output line pair GIOp3. The local sense amplifier circuit in the third local sense amplifier region LSAB3 may input and output the data DTA stored by the memory cell in the 1_1 sub-memory array SMA11' through the third global input/output line pair GIOp3.

At least a part of the fourth local sense amplifier region LSAB4 may overlap the 1_1 sub-memory array SMA11' in the third direction D3. The local sense amplifier circuit disposed in the fourth local sense amplifier region LSAB4 may be connected to at least a part of the bit lines of the 1_1 sub-memory array SMA11', which is the normal region NR. The memory cell in the normal region NR may store the data DTA, and the local sense amplifier circuit in the fourth local sense amplifier region LSAB4 may be connected to the third global input/output line pair GIOp4. The local sense amplifier circuit in the fourth local sense amplifier region LSAB4 may input and output the data DTA stored by the memory cell in the 1_1 sub-memory array SMA11' through the fourth global input/output line pair GIOp4.

At least a part of the fifth local sense amplifier region LSAB5 may overlap the 1_1 sub-memory array SMA11' and the 1_2 sub-memory array SMA12' in the third direction D3. The local sense amplifier circuit disposed in the fifth local sense amplifier region LSAB5 may be connected to at least a part of the bit lines of the 1_1 sub-memory array SMA11', which is the normal region NR, and to at least a part of the bit lines corresponding to the normal region NR in the 1_2 sub-memory array SMA12'. The memory cell in the normal region NR may store the data DTA, and the local sense amplifier circuit in the fifth local sense amplifier region LSAB5 may be connected to the fifth global input/output line pair GIOp5. The local sense amplifier circuit in the fifth local sense amplifier region LSAB5 may input and output the data DTA stored by the memory cell in the 1_1 sub-memory array SMA11' and the 1_2 sub-memory array SMA12' through the fifth global input/output line pair GIOp5.

At least a part of the sixth local sense amplifier region LSAB6 may overlap the 1_2 sub-memory array SMA12' in the third direction D3. The local sense amplifier circuit disposed in the sixth local sense amplifier region LSAB6 may be connected to at least a part of the bit lines corresponding to the normal region NR in the 1_2 sub-memory array SMA12'. The memory cell in the normal region NR may store the data DTA, and the local sense amplifier circuit in the sixth local sense amplifier region LSAB6 may be connected to a sixth global input/output line pair GIOp6. The local sense amplifier circuit in the sixth local sense amplifier region LSAB6 may input and output the data DTA stored by the memory cell in the 1_2 sub-memory array SMA12' through the sixth global input/output line pair GIOp6.

At least a part of the seventh local sense amplifier region LSAB7 may overlap the 1_2 sub-memory array SMA12' in the third direction D3. The local sense amplifier circuit disposed in the seventh local sense amplifier region LSAB7 may be connected to at least a part of the bit lines corresponding to the normal region NR in the 1_2 sub-memory array SMA12'. The memory cell in the normal region NR may store the data DTA, and the local sense amplifier circuit in the seventh local sense amplifier region LSAB7 may be connected to a seventh global input/output line pair GIOp7. The local sense amplifier circuit in the seventh local sense amplifier region LSAB7 may input and output the data DTA stored by the memory cell in the 1_2 sub-memory array SMA12' through the seventh global input/output line pair GIOp7.

At least a part of the eighth local sense amplifier region LSAB8 may overlap the 1_2 sub-memory array SMA12' in the third direction D3. The local sense amplifier circuit disposed in the eighth local sense amplifier region LSAB8 may be connected to at least a part of the bit lines of the 1_2 sub-memory array SMA12', which is the normal region NR. The memory cell in the normal region NR may store the data DTA, and the local sense amplifier circuit in the eighth local sense amplifier region LSAB8 may be connected to the eighth global input/output line pair GIOp8. The local sense amplifier circuit in the eighth local sense amplifier region LSAB8 may input and output the data DTA stored by the memory cell in the 1_2 sub-memory array SMA12' through the eighth global input/output line pair GIOp8.

At least a part of the ninth local sense amplifier region LSAB9 may overlap the 1_2 sub-memory array SMA12' and the 1_3 sub-memory array SMA13' in the third direction D3. The local sense amplifier circuit disposed in the ninth local sense amplifier region LSAB9 may be connected to at least a part of the bit lines corresponding to the redundancy region RR in the 1_2 sub-memory array SMA12' and at least a part of the bit lines corresponding to the redundancy region RR in the 1_3 sub-memory array SMA13'. The memory cell in the redundancy region RR may store the parity data PRT, and the local sense amplifier circuit in the ninth local sense amplifier region LSAB9 may be connected to a ninth global input/output line pair GIOp9. The local sense amplifier circuit in the ninth local sense amplifier region LSAB9 may input and output the parity data PRT stored by the memory cell in the 1_2 sub-memory array SMA12' and the 1_3 sub-memory array SMA13' through the ninth global input/output line pair GIOp9.

At least a part of the tenth local sense amplifier region LSAB10 may overlap the 1_3 sub-memory array SMA13' in the third direction D3. The local sense amplifier circuit disposed in the tenth local sense amplifier region LSAB10 may be connected to at least a part of the bit lines of the 1_3 sub-memory array SMA13', which is the normal region NR. The memory cell in the normal region NR may store the data DTA, and the local sense amplifier circuit in the tenth local sense amplifier region LSAB10 may be connected to a tenth global input/output line pair GIOp10. The local sense amplifier circuit in the tenth local sense amplifier region LSAB10 may input and output the data DTA stored by the memory cell in the 1_3 sub-memory array SMA13' through the tenth global input/output line pair GIOp10.

At least a part of the eleventh local sense amplifier region LSAB11 may overlap the 1_3 sub-memory array SMA13' in the third direction D3. The local sense amplifier circuit disposed in the eleventh local sense amplifier region LSAB11 may be connected to at least a part of the bit lines of the 1_3 sub-memory array SMA13', which is the normal region NR. The memory cell in the normal region NR may store the data DTA, and the local sense amplifier circuit in the eleventh local sense amplifier region LSAB11 may be connected to an eleventh global input/output line pair GIOp11. The local sense amplifier circuit in the eleventh local sense amplifier region LSAB11 may input and output the data DTA stored by the memory cell in the 1_3 sub-memory array SMA13' through the eleventh global input/output line pair GIOp11.

At least a part of the twelfth local sense amplifier region LSAB12 may overlap the 1_3 sub-memory array SMA13' in the third direction D3. The local sense amplifier circuit disposed in the twelfth local sense amplifier region LSAB12 may be connected to at least a part of the bit lines of the 1_3 sub-memory array SMA13', which is the normal region NR. The memory cell in the normal region NR may store the data DTA, and the local sense amplifier circuit in the twelfth local sense amplifier region LSAB12 may be connected to a twelfth global input/output line pair GIOp12. The local sense amplifier circuit in the twelfth local sense amplifier region LSAB12 may input and output the data DTA stored by the memory cell in the 1_3 sub-memory array SMA13' through the twelfth global input/output line pair GIOp12.

At least a part of the thirteenth local sense amplifier region LSAB13 may overlap the 1_3 sub-memory array SMA13' and the 1_4 sub-memory array SMA14' in the third direction D3. The local sense amplifier circuit disposed in the thirteenth local sense amplifier region LSAB13 may be connected to at least a part of the bit lines corresponding to the normal region NR in the 1_3 sub-memory array SMA13', and to at least a part of the bit lines of the 1_4 sub-memory array SMA14'. The memory cell in the normal region NR may store the data DTA, and the local sense amplifier circuit in the thirteenth local sense amplifier region LSAB13 may be connected to the thirteenth global input/output line pair GIOp13. The local sense amplifier circuit in the thirteenth local sense amplifier region LSAB13 may input and output the data DTA stored by the memory cell in the 1_3 sub-memory array SMA13' and the 1_4 sub-memory array SMA14' through the thirteenth global input/output line pair GIOp13.

At least a part of the fourteenth local sense amplifier region LSAB14 may overlap the 1_4 sub-memory array SMA14' in the third direction D3. The local sense amplifier circuit disposed in the fourteenth local sense amplifier region LSAB14 may be connected to at least a part of the bit lines of the 1_4 sub-memory array SMA14', which is the normal region NR. The memory cell in the normal region NR may store the data DTA, and the local sense amplifier circuit in the fourteenth local sense amplifier region LSAB14 may be connected to the fourteenth global input/output line pair GIOp14. The local sense amplifier circuit in the fourteenth local sense amplifier region LSAB14 may input and output the data DTA stored by the memory cell in the 1_4 sub-memory array SMA14' through the fourteenth global input/output line pair GIOp14.

At least a part of the fifteenth local sense amplifier region LSAB15 may overlap the 1_4 sub-memory array SMA14' in the third direction D3. The local sense amplifier circuit disposed in the fifteenth local sense amplifier region LSAB15 may be connected to at least a part of the bit lines of the 1_4 sub-memory array SMA14', which is the normal region NR. The memory cell in the normal region NR may store the data DTA, and the local sense amplifier circuit in the fifteenth local sense amplifier region LSAB15 may be connected to a fifteenth global input/output line pair GIOp15. The local sense amplifier circuit in the fifteenth local sense amplifier region LSAB15 may input and output the data DTA stored by the memory cell in the 1_4 sub-memory array SMA14' through the fifteenth global input/output line pair GIOp15.

At least a part of the sixteenth local sense amplifier region LSAB16 may overlap the 1_4 sub-memory array SMA14' in the third direction D3. The local sense amplifier circuit disposed in the sixteenth local sense amplifier region LSAB16 may be connected to at least a part of the bit lines of the 1_4 sub-memory array SMA14', which is the normal region NR. The memory cell in the normal region NR may store the data DTA, and the local sense amplifier circuit in the sixteenth local sense amplifier region LSAB16 may be connected to a sixteenth global input/output line pair GIOp16. The local sense amplifier circuit in the sixteenth local sense amplifier region LSAB16 may input and output the data DTA stored by the memory cell in the 1_4 sub-memory array SMA14' through the sixteenth global input/output line pair GIOp16.

At least a part of the seventeenth local sense amplifier region LSAB17 may overlap the 1_4 sub-memory array SMA14' in the third direction D3. The local sense amplifier circuit disposed in the seventeenth local sense amplifier region LSAB17 may be connected to at least a part of the bit lines of the 1_4 sub-memory array SMA14', which is the normal region NR. The memory cell in the normal region NR may store the data DTA, and the local sense amplifier circuit in the seventeenth local sense amplifier region LSAB17 may be connected to a seventeenth global input/output line pair GIOp17. The local sense amplifier circuit in the seventeenth local sense amplifier region LSAB17 may input and output the data DTA stored by the memory cell in the 1_4 sub-memory array SMA14' through the seventeenth global input/output line pair GIOp17.

The first to seventeenth local sense amplifier regions LSAB1 to LSAB17 may be arranged in the second direction D2. The first to seventeenth local sense amplifier regions LSAB1 to LSAB17 may be disposed above the 1_1 to 1_4 sub-memory arrays SMA11' to SMA14' based on the first direction D1.

The first to eighth local sense amplifier regions LSAB1 to LSAB8 and the tenth to seventeenth local sense amplifier regions LSAB10 to LSAB17 may correspond to the normal region NR in the first row block RB1', and the ninth local sense amplifier region LSAB9 may correspond to the redundancy region RR in the first row block RB1'. The normal region NR and the redundancy region RR may be divided based on the bit lines included in the first row block RB1'. For example, the normal region NR and the redundancy region RR may be differentiated from each other based on bit lines connected thereto.

Depending on the embodiments, the first to seventeenth local sense amplifier regions LSAB1 to LSAB17 may include k bit line sense amplifiers. Accordingly, each of the local sense amplifier circuits included in the first to seventeenth local sense amplifier regions LSAB1 to LSAB17 may be connected to 2k bit lines. Considering the number of bit lines connected to each of the local sense amplifier circuits of the first through seventeenth local sense amplifier regions LSAB1 through LSAB17, there may be 8k+X bit lines included in each of the plurality of sub-memory arrays SMA11' to SMA84'. Depending on the embodiments, the k may be 256 and the X may be 128.

Depending on the embodiments, the ratio of the number of 2k bit lines connected to the local sense amplifier circuit in each of the first to seventeenth local sense amplifier regions LSAB1 to LSAB17 to the number of 8k+X bit lines included in each of the plurality of sub-memory arrays SMA11' to SMA84' may be 1 to x2. The x2 may be a rational number rather than an integer greater than 4. For example, x2 may be a rational number that is not a whole number greater than 4 (e.g., x2 is not 5, 6, 7, etc.). Depending on the embodiments, the x2 may be within 4.05 to 4.35, and preferably within 4.1 to 4.3. In other words, x2 may be in a range from 4.05 to 4.35 (e.g., in a range from 4.1 to 4.3).

The first row block RB1' may allocate a region corresponding to a specific local sense amplifier circuit as the redundancy region RR through the arrangement of the 1_1 to 1_4 sub-memory arrays SMA11' to SMA14' and the first to seventeenth local sense amplifier regions LSAB1 to LSAB17, without arrangement of sub-memory arrays for ECC cells or redundancy cells. The arrangement of the first row block RB1' as described above may reduce the sub-word driver region disposed on the second bank array 210b (e.g., may reduce an area of the sub word line driver region) and improve the area efficiency of the configurations within the memory device.

Although not shown, the memory device 10 may include a local sense amplifier region disposed on the lower side of the 1_1 to 1_4 sub-memory arrays SMA11' to SMA14' in the first direction D1, in addition to the first to seventeenth local sense amplifier regions LSAB1 to LSAB17 on the upper side.

Although not shown, at least a part of the first to seventeenth local sense amplifier regions LSAB1 to LSAB17 may overlap 2_1 to 2_4 sub-memory arrays SMA21' to SMA24' in the third direction D3. The local sense amplifier circuits disposed in the first to seventeenth local sense amplifier regions LSAB1 to LSAB17 may be connected to the bit lines of the 2_1 to 2_4 sub-memory arrays SMA21' to SMA24'.

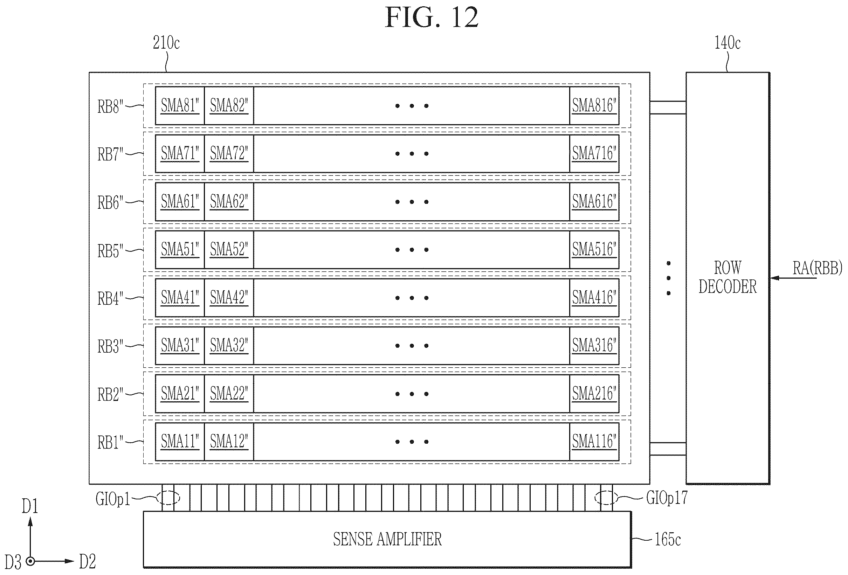

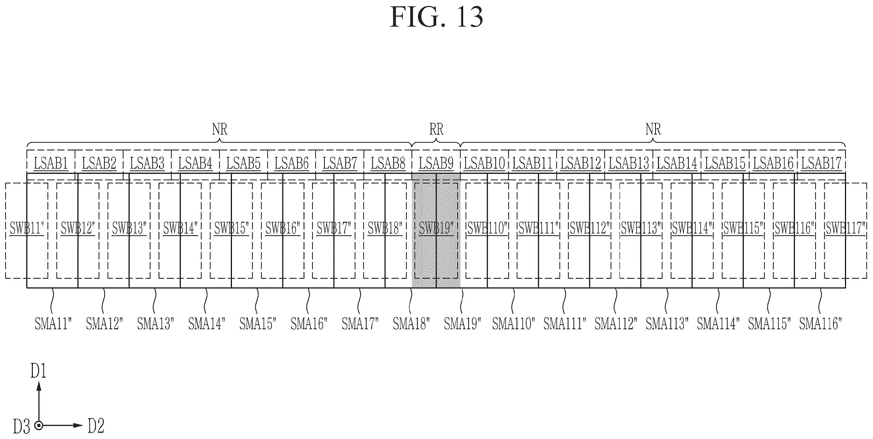

FIG. 12 is a top plan view for describing a bank array according to some further embodiments. FIG. 13 is a top plan view for describing the first row block of FIG. 12. A third bank array 210c, first to eighth row blocks RB1" to RB8", and the first to seventeenth local sense amplifier regions LSAB1 to LSAB17 may respectively correspond to the first bank array 210a, the first to eighth row blocks RB1 to RB8, and the first to seventeenth local sense amplifier regions LSAB1 to LSAB17 of FIGS. 5 and 6. For ease of description below, the third bank array 210c, the first to eighth row blocks RB1" to RB8", and the first to seventeenth local sense amplifier regions LSAB1 to LSAB17 will be described, focusing on the differences from the first bank array 210a, the first to eighth row blocks RB1 to RB8, and the first to seventeenth local sense amplifier regions LSAB1 to LSAB17 of FIGS. 5 and 6.

Referring to FIGS. 2, 3, 12, and 13, the components and arrangement of the components within the memory device 10 will be described below based on the third bank array 210c. It will be understood that the description of the third bank array 210c may be applied in the same or similar manner to the rest of the bank arrays 210a to 210s.

The third bank array 210c may include a plurality of sub-memory arrays SMA11" to SMA816". The plurality of sub-memory arrays SMA11" to SMA816" may be connected to a third row decoder 140c and a third sense amplifier 165c. The third row decoder 140c may include a plurality of sub-word line drivers, and among the plurality of sub-word line drivers, a sub-word line driver corresponding to the row address RA may be activated. The activated sub-word line driver may provide a driving voltage to the word line corresponding to the row address RA.

The third sense amplifier 165c may be connected to the plurality of sub-memory arrays SMA11" to SMA816" through the first to seventeenth global input/output line pairs GIOp1 to GIOp17. Depending on the embodiments, any one of the first to seventeenth global input/output line pairs GIOp1 to GIOp17 connected to the third sense amplifier 165c may be connected to local sense amplifier circuits arranged in the second direction D2. For example, among the local sense amplifier circuits connected to 1_1 to 8_1 sub-memory arrays SMA11" to SMA81", some of the local sense amplifier circuits arranged in the first direction D1 may be connected to the third sense amplifier 165c through the first global input/output line pair GIOp1.

In FIG. 12, the third sense amplifier 165c and the third row decoder 140c are shown as arranged to non-overlap on a plane with the third bank array 210c, but the arrangement of the third sense amplifier 165c and the third row decoder 140c shown in FIG. 12 is for describing the connection relationship with the components. Depending on the embodiments, at least a part of the third sense amplifier 165c and at least a part of the third row decoder 140c may overlap the third bank array 210c in the third direction D3.

The plurality of sub-memory arrays SMA11" to SMA816" may be divided into the first to eighth row blocks RB1" to RB8" arranged in the first direction D1 by the row block identification bits RBB, which are some bits of the row address RA. For example, by the row block identification bit RBB, which is the upper 3 bits of the row address RA, the plurality of sub-memory arrays SMA11" to SMA816" may be divided into the first to eighth row blocks RB1" to RB8" arranged in the first direction D1. Although the third bank array 210c of FIG. 12 includes a plurality of sub-memory arrays arranged in 8 row blocks and 8 column blocks, the present disclosure is not limited thereto, and the number of row blocks and column blocks included in the bank array may vary depending on the embodiments.

The first row block RB1" may include 1_1 to 1_16 sub-memory arrays SMA11" to SMA116" that are divided into the same row block by the row block identification bit RBB. The 1_1 to 1_16 sub-memory arrays SMA11" to SMA116" may be arranged in the second direction D2. Hereinafter, the components and arrangement of the components within the third bank array 210c will be described based on the first row block RB1". It will be understood that the description of the first row block RB1" may be applied in the same or similar manner to the rest of the row blocks RB1" to RB8".

Each of the 1_1 to 1_16 sub-memory arrays SMA11" to SMA116" may include a plurality of word lines extending in the second direction D2, a plurality of bit lines extending in the first direction D1, and memory cells connected to the plurality of word lines and the plurality of bit lines.

Depending on the embodiments, the 1_1 to 1_16 sub-memory arrays SMA11" to SMA116" may include a predetermined first number of word lines, and a predetermined second number of bit lines that intersect one word line. Each of the 1_1 to 1_16 sub-memory arrays SMA11" to SMA116" may include the same number of word lines and the same number of bit lines. The number of memory cells connected to one word line in the 1_1 to 1_16 sub-memory arrays SMA11" to SMA116" is the same. For example, the number of memory cells connected to one word line of the 1_1 sub-memory array SMA11" is equal to the number of memory cells connected to one word line of a 1_2 sub-memory array SMA12".

Referring to FIG. 13, the 1_1 sub-memory array SMA11" may be arranged to overlap at least a part of a 1_1 sub-word line driver region SWB11" and at least a part of a 1_2 sub-word line driver region SWB 12" in the third direction D3. Depending on the embodiments, the 1_1 sub-memory array SMA11" may include word lines connected to at least a part of the sub-word line driver disposed in the 1_1 sub-word line driver region SWB11" and to at least a part of the sub-word line driver disposed in the 1_2 sub-word line driver region SWB12".

A 1_2 sub-memory array SMA12" may be arranged to overlap at least a part of the 1_2 sub-word line driver region SWB 12" and at least a part of a 1_3 sub-word line driver region SWB13" in the third direction D3. Depending on the embodiments, the 1_2 sub-memory array SMA12" may include word lines connected to at least a part of the sub-word line driver disposed in the 1_2 sub-word line driver region SWB12" and to at least a part of the sub-word line driver disposed in the 1_3 sub-word line driver region SWB 13".

A 1_3 sub-memory array SMA13" may be arranged to overlap at least the part of the 1_3 sub-word line driver region SWB 13" and at least a part of a 1_4 sub-word line driver region SWB14" in the third direction D3. Depending on the embodiments, the 1_3 sub-memory array SMA13" may include word lines connected to at least a part of the sub-word line driver disposed in the 1_3 sub-word line driver region SWB13" and to at least a part of the sub-word line driver disposed in the 1_4 sub-word line driver region SWB 14".

A 1_4 sub-memory array SMA14" may be arranged to overlap at least the part of the 1_4 sub-word line driver region SWB 14" and at least a part of a 1_5 sub-word line driver region SWB15" in the third direction D3. Depending on the embodiments, the 1_4 sub-memory array SMA14" may include word lines connected to at least a part of the sub-word line driver disposed in the 1_4 sub-word line driver region SWB14" and to at least a part of the sub-word line driver disposed in the 1_5 sub-word line driver region SWB 15".

A 1_5 sub-memory array SMA15" may be arranged to overlap at least the part of the 1_5 sub-word line driver region SWB15" and at least a part of a 1_6 sub-word line driver region SWB16" in the third direction D3. Depending on the embodiments, the 1_5 sub-memory array SMA15" may include word lines connected to at least a part of the sub-word line driver disposed in the 1_5 sub-word line driver region SWB15" and to at least a part of the sub-word line driver disposed in the 1_6 sub-word line driver region SWB 16".

A 1_6 sub-memory array SMA16" may be arranged to overlap at least the part of the 1_6 sub-word line driver region SWB 16" and at least a part of a 1_7 sub-word line driver region SWB17" in the third direction D3. Depending on the embodiments, the 1_6 sub-memory array SMA16" may include word lines connected to at least a part of the sub-word line driver disposed in the 1_6 sub-word line driver region SWB16" and to at least a part of the sub-word line driver disposed in the 1_7 sub-word line driver region SWB17".

A 1_7 sub-memory array SMA17" may be arranged to overlap at least the part of the 1_7 sub-word line driver region SWB 17" and at least a part of a 1_8 sub-word line driver region SWB18" in the third direction D3. Depending on the embodiments, the 1_7 sub-memory array SMA17" may include word lines connected to at least a part of the sub-word line driver disposed in the 1_7 sub-word line driver region SWB17" and to at least a part of the sub-word line driver disposed in the 1_8 sub-word line driver region SWB18".

A 1_8 sub-memory array SMA18" may be arranged to overlap at least the part of the 1_8 sub-word line driver region SWB 18" and at least a part of a 1_9 sub-word line driver region SWB19" in the third direction D3. Depending on the embodiments, the 1_8 sub-memory array SMA18" may include word lines connected to at least a part of the sub-word line driver disposed in the 1_8 sub-word line driver region SWB18" and to at least a part of the sub-word line driver disposed in the 1_9 sub-word line driver region SWB19".

A 1_9 sub-memory array SMA19" may be arranged to overlap at least the part of the 1_9 sub-word line driver region SWB19" and at least a part of a 1_10 sub-word line driver region SWB110" in the third direction D3. Depending on the embodiments, the 1_9 sub-memory array SMA19" may include word lines connected to at least a part of the sub-word line driver disposed in the 1_9 sub-word line driver region SWB19" and to at least a part of the sub-word line driver disposed in the 1_10 sub-word line driver region SWB110".

A 1_10 sub-memory array SMA110" may be arranged to overlap at least the part of the 1_10 sub-word line driver region SWB110" and at least a part of a 1_11 sub-word line driver region SWB111" in the third direction D3. Depending on the embodiments, the 1_10 sub-memory array SMA110" may include word lines connected to at least a part of the sub-word line driver disposed in the 1_10 sub-word line driver region SWB110" and to at least a part of the sub-word line driver disposed in the 1_11 sub-word line driver region SWB111".

A 1_11 sub-memory array SMA111" may be arranged to overlap at least the part of the 1_11 sub-word line driver region SWB111" and at least a part of a 1_12 sub-word line driver region SWB112" in the third direction D3. Depending on the embodiments, the 1_11 sub-memory array SMA111" may include word lines connected to at least a part of the sub-word line driver disposed in the 1_11 sub-word line driver region SWB111" and to at least a part of the sub-word line driver disposed in the 1_12 sub-word line driver region SWB112".

A 1_12 sub-memory array SMA112" may be arranged to overlap at least the part of the 1_12 sub-word line driver region SWB112" and at least a part of a 1_13 sub-word line driver region SWB113" in the third direction D3. Depending on the embodiments, the 1_12 sub-memory array SMA112" may include word lines connected to at least a part of the sub-word line driver disposed in the 1_12 sub-word line driver region SWB112" and to at least a part of the sub-word line driver disposed in the 1_13 sub-word line driver region SWB113".

A 1_13 sub-memory array SMA113" may be arranged to overlap at least the part of the 1_13 sub-word line driver region SWB113" and at least a part of a 1_14 sub-word line driver region SWB114" in the third direction D3. Depending on the embodiments, the 1_13 sub-memory array SMA113" may include word lines connected to at least a part of the sub-word line driver disposed in the 1_13 sub-word line driver region SWB 113" and to at least a part of the sub-word line driver disposed in the 1_14 sub-word line driver region SWB114".

A 1_14 sub-memory array SMA114" may be arranged to overlap at least the part of the 1_14 sub-word line driver region SWB114" and at least a part of a 1_15 sub-word line driver region SWB115" in the third direction D3. Depending on the embodiments, the 1_14 sub-memory array SMA114" may include word lines connected to at least a part of the sub-word line driver disposed in the 1_14 sub-word line driver region SWB114" and to at least a part of the sub-word line driver disposed in the 1_15 sub-word line driver region SWB115".

A 1_15 sub-memory array SMA115" may be arranged to overlap at least the part of the 1_15 sub-word line driver region SWB115" and at least a part of a 1_16 sub-word line driver region SWB116" in the third direction D3. Depending on the embodiments, the 1_15 sub-memory array SMA115" may include word lines connected to at least a part of the sub-word line driver disposed in the 1_15 sub-word line driver region SWB115" and to at least a part of the sub-word line driver disposed in the 1_16 sub-word line driver region SWB116".

A 1_16 sub-memory array SMA116" may be arranged to overlap at least the part of the 1_16 sub-word line driver region SWB116" and at least a part of a 1_17 sub-word line driver region SWB117" in the third direction D3. Depending on the embodiments, the 1_16 sub-memory array SMA116" may include word lines connected to at least a part of the sub-word line driver disposed in the 1_16 sub-word line driver region SWB116" and to at least a part of the sub-word line driver disposed in the 1_17 sub-word line driver region SWB117".

The 1_1 to 1_17 sub-word line driver regions SWB11" to SWB117" may be arranged at the boundary between the 1_1 to 1_16 sub-memory arrays SMA11" to SMA116" or on one side of the first row block RB1". The 1_1 to 1_17 sub-word line driver regions SWB11" to SWB117" may be arranged in the second direction D2.

Depending on the embodiments, the local sense amplifier circuits included in each of first to seventeenth local sense amplifier regions LSAB1 to LSAB17 may be connected to a predetermined third number of bit lines. The circuit disposed in each of the first to seventeenth local sense amplifier regions LSAB1 to LSAB17 operates as a single local sense amplifier circuit, amplifying the difference in voltage levels detected in a plurality of bit line pairs and providing the difference to a pair of global input/output lines. Each of the local sense amplifier circuits in the first to seventeenth local sense amplifier regions LSAB1 to LSAB17 is connected to the same number of bit lines, and the local sense amplifier circuit may receive differences in amplified voltage levels from some of the bit lines based on a column selection signal.

At least a part of the first local sense amplifier region LSAB1 may overlap the 1_1 sub-memory array SMA11" in the third direction D3. The local sense amplifier circuit disposed in the first local sense amplifier region LSAB1 may be connected to at least a part of the bit lines of the 1_1 sub-memory array SMA11", which is the normal region NR. The memory cell in the normal region NR may store the data DTA, and the local sense amplifier circuit in the first local sense amplifier region LSAB1 may be connected to the first global input/output line pair GIOp1. The local sense amplifier circuit in the first local sense amplifier region LSAB1 may input and output the data DTA stored by the memory cell in the 1_1 sub-memory array SMA11" through the first global input/output line pair GIOp1.

At least a part of the second local sense amplifier region LSAB2 may overlap the 1_1 sub-memory array SMA11" and the 1_2 sub-memory array SMA12" in the third direction D3. The local sense amplifier circuit disposed in the second local sense amplifier region LSAB2 may be connected to at least a part of the bit lines of the 1_1 sub-memory array SMA11" and the 1_2 sub-memory array SMA12", which is the normal region NR. The memory cell in the normal region NR may store the data DTA, and the local sense amplifier circuit in the second local sense amplifier region LSAB2 may be connected to the second global input/output line pair GIOp2. The local sense amplifier circuit in the second local sense amplifier region LSAB2 may input and output the data DTA stored by the memory cell in the 1_1 sub-memory array SMA11" and the 1_2 sub-memory array SMA12" through the second global input/output line pair GIOp2.

At least a part of the third local sense amplifier region LSAB3 may overlap the 1_2 sub-memory array SMA12" and the 1_3 sub-memory array SMA13" in the third direction D3. The local sense amplifier circuit disposed in the third local sense amplifier region LSAB3 may be connected to at least a part of the bit lines of the 1_2 sub-memory array SMA12", which is the normal region NR, and to at least a part of the bit lines of the 1_3 sub-memory array SMA13". The memory cell in the normal region NR may store the data DTA, and the local sense amplifier circuit in the third local sense amplifier region LSAB3 may be connected to a third global input/output line pair GIOp3. The local sense amplifier circuit in the third local sense amplifier region LSAB3 may input and output the data DTA stored by the memory cell in the 1_2 sub-memory array SMA12" and the 1_3 sub-memory array SMA13" through the third global input/output line pair GIOp3.

At least a part of the fourth local sense amplifier region LSAB4 may overlap the 1_3 sub-memory array SMA13" and the 1_4 sub-memory array SMA14" in the third direction D3. The local sense amplifier circuit disposed in the fourth local sense amplifier region LSAB4 may be connected to at least a part of the bit lines of the 1_3 sub-memory array SMA13", which is the normal region NR, and to at least a part of the bit lines of the 1_4 sub-memory array SMA14". The memory cell in the normal region NR may store the data DTA, and the local sense amplifier circuit in the fourth local sense amplifier region LSAB4 may be connected to the third global input/output line pair GIOp4. The local sense amplifier circuit in the fourth local sense amplifier region LSAB4 may input and output the data DTA stored by the memory cell in the 1_3 sub-memory array SMA13" and the 1_4 sub-memory array SMA14" through the fourth global input/output line pair GIOp4.

At least a part of the fifth local sense amplifier region LSAB5 may overlap the 1_4 sub-memory array SMA14" and the 1_5 sub-memory array SMA15" in the third direction D3. The local sense amplifier circuit disposed in the fifth local sense amplifier region LSABS may be connected to at least a part of the bit lines of the 1_4 sub-memory array SMA14", which is the normal region NR, and to at least a part of the bit lines of the 1_5 sub-memory array SMA15". The memory cell in the normal region NR may store the data DTA, and the local sense amplifier circuit in the fifth local sense amplifier region LSABS may be connected to the fifth global input/output line pair GIOp5. The local sense amplifier circuit in the fifth local sense amplifier region LSAB5 may input and output the data DTA stored by the memory cell in the 1_4 sub-memory array SMA14" and the 1_5 sub-memory array SMA15" through the fifth global input/output line pair GIOp5.

At least a part of the sixth local sense amplifier region LSAB6 may overlap the 1_5 sub-memory array SMA15" and the 1_6 sub-memory array SMA16" in the third direction D3. The local sense amplifier circuit disposed in the sixth local sense amplifier region LSAB6 may be connected to at least a part of the bit lines of the 1_5 sub-memory array SMA15", which is the normal region NR, and to at least a part of the bit lines of the 1_6 sub-memory array SMA16". The memory cell in the normal region NR may store the data DTA, and the local sense amplifier circuit in the sixth local sense amplifier region LSAB6 may be connected to a sixth global input/output line pair GIOp6. The local sense amplifier circuit in the sixth local sense amplifier region LSAB6 may input and output the data DTA stored by the memory cell in the 1_5 sub-memory array SMA15" and the 1_6 sub-memory array SMA16" through the sixth global input/output line pair GIOp6.

At least a part of the seventh local sense amplifier region LSAB7 may overlap the 1_6 sub-memory array SMA16" and the 1_7 sub-memory array SMA17" in the third direction D3. The local sense amplifier circuit disposed in the seventh local sense amplifier region LSAB7 may be connected to at least a part of the bit lines of the 1_6 sub-memory array SMA16", which is the normal region NR, and to at least a part of the bit lines of the 1_7 sub-memory array SMA17". The memory cell in the normal region NR may store the data DTA, and the local sense amplifier circuit in the seventh local sense amplifier region LSAB7 may be connected to a seventh global input/output line pair GIOp7. The local sense amplifier circuit in the seventh local sense amplifier region LSAB7 may input and output the data DTA stored by the memory cell in the 1_6 sub-memory array SMA16" and the 1_7 sub-memory array SMA17" through the seventh global input/output line pair GIOp7.

At least a part of the eighth local sense amplifier region LSAB8 may overlap the 1_7 sub-memory array SMA17" and the 1_8 sub-memory array SMA18" in the third direction D3. The local sense amplifier circuit disposed in the eighth local sense amplifier region LSAB8 may be connected to at least a part of the bit lines of the 1_7 sub-memory array SMA17", which is the normal region NR, and to at least a part of the bit lines of the 1_8 sub-memory array SMA18". The memory cell in the normal region NR may store the data DTA, and the local sense amplifier circuit in the eighth local sense amplifier region LSAB8 may be connected to the eighth global input/output line pair GIOp8. The local sense amplifier circuit in the eighth local sense amplifier region LSAB8 may input and output the data DTA stored by the memory cell in the 1_7 sub-memory array SMA17" and the 1_8 sub-memory array SMA18" through the eight global input/output line pair GIOp8.

At least a part of the ninth local sense amplifier region LSAB9 may overlap the 1_8 sub-memory array SMA18" and the 1_9 sub-memory array SMA19" in the third direction D3. The local sense amplifier circuit disposed in the ninth local sense amplifier region LSAB9 may be connected to at least a part of the bit lines corresponding to the redundancy region RR in the 1_8 sub-memory array SMA18" and at least a part of the bit lines corresponding to the redundancy region RR in the 1_9 sub-memory array SMA19". The memory cell in the redundancy region RR may store the parity data PRT, and the local sense amplifier circuit in the ninth local sense amplifier region LSAB9 may be connected to a ninth global input/output line pair GIOp9. The local sense amplifier circuit in the ninth local sense amplifier region LSAB9 may input and output the parity data PRT stored by the memory cell in the 1_8 sub-memory array SMA18" and the 1_9 sub-memory array SMA19" through the ninth global input/output line pair GIOp9.

At least a part of the tenth local sense amplifier region LSAB10 may overlap the 1_9 sub-memory array SMA19" and the 1_10 sub-memory array SMA110" in the third direction D3. The local sense amplifier circuit disposed in the tenth local sense amplifier region LSAB10 may be connected to at least a part of the bit lines corresponding to the normal region NR in the 1_9 sub-memory array SMA19" and at least a part of the bit lines corresponding to the normal region NR in the 1_10 sub-memory array SMA110". The memory cell in the normal region NR may store the data DTA, and the local sense amplifier circuit in the tenth local sense amplifier region LSAB10 may be connected to a tenth global input/output line pair GIOp10. The local sense amplifier circuit in the tenth local sense amplifier region LSAB10 may input and output the data DTA stored by the memory cell in the 1_9 sub-memory array SMA19" and the 1_10 sub-memory array SMA110" through the tenth global input/output line pair GIOp10.

At least a part of the eleventh local sense amplifier region LSAB11 may overlap the 1_10 sub-memory array SMA110" and the 1_11 sub-memory array SMA111" in the third direction D3. The local sense amplifier circuit disposed in the eleventh local sense amplifier region LSAB11 may be connected to at least a part of the bit lines of the 1_10 sub-memory array SMA110", which is the normal region NR, and to at least a part of the bit lines of the 1_11 sub-memory array SMA111". The memory cell in the normal region NR may store the data DTA, and the local sense amplifier circuit in the eleventh local sense amplifier region LSAB11 may be connected to an eleventh global input/output line pair GIOp11. The local sense amplifier circuit in the eleventh local sense amplifier region LSAB11 may input and output the data DTA stored by the memory cell in the 1_10 sub-memory array SMA110" and the 1_11 sub-memory array SMA111" through the eleventh global input/output line pair GIOp11.

At least a part of the twelfth local sense amplifier region LSAB12 may overlap the 1_11 sub-memory array SMA111" and the 1_12 sub-memory array SMA112" in the third direction D3. The local sense amplifier circuit disposed in the twelfth local sense amplifier region LSAB12 may be connected to at least a part of the bit lines of the 1_11 sub-memory array SMA111", which is the normal region NR, and to at least a part of the bit lines of the 1_12 sub-memory array SMA112". The memory cell in the normal region NR may store the data DTA, and the local sense amplifier circuit in the twelfth local sense amplifier region LSAB12 may be connected to a twelfth global input/output line pair GIOp12. The local sense amplifier circuit in the twelfth local sense amplifier region LSAB12 may input and output the data DTA stored by the memory cell in the 1_11 sub-memory array SMA111" and the 1_12 sub-memory array SMA112" through the twelfth global input/output line pair GIOp12.

At least a part of the thirteenth local sense amplifier region LSAB13 may overlap the 1_12 sub-memory array SMA112" and the 1_13 sub-memory array SMA113" in the third direction D3. The local sense amplifier circuit disposed in the thirteenth local sense amplifier region LSAB13 may be connected to at least a part of the bit lines of the 1_12 sub-memory array SMA112", which is the normal region NR, and to at least a part of the bit lines of the 1_13 sub-memory array SMA113". The memory cell in the normal region NR may store the data DTA, and the local sense amplifier circuit in the thirteenth local sense amplifier region LSAB13 may be connected to a thirteenth global input/output line pair GIOp13. The local sense amplifier circuit in the thirteenth local sense amplifier region LSAB13 may input and output the data DTA stored by the memory cell in the 1_12 sub-memory array SMA112" and the 1_13 sub-memory array SMA113" through the thirteenth global input/output line pair GIOp13.

At least a part of the fourteenth local sense amplifier region LSAB14 may overlap the 1_13 sub-memory array SMA113" and the 1_14 sub-memory array SMA114" in the third direction D3. The local sense amplifier circuit disposed in the fourteenth local sense amplifier region LSAB14 may be connected to at least a part of the bit lines of the 1_13 sub-memory array SMA113", which is the normal region NR, and to at least a part of the bit lines of the 1_14 sub-memory array SMA114". The memory cell in the normal region NR may store the data DTA, and the local sense amplifier circuit in the fourteenth local sense amplifier region LSAB14 may be connected to a fourteenth global input/output line pair GIOp14. The local sense amplifier circuit in the fourteenth local sense amplifier region LSAB14 may input and output the data DTA stored by the memory cell in the 1_13 sub-memory array SMA113" and the 1_14 sub-memory array SMA114" through the thirteenth global input/output line pair GIOp14.

At least a part of the fifteenth local sense amplifier region LSAB15 may overlap the 1_14 sub-memory array SMA114" and the 1_15 sub-memory array SMA115" in the third direction D3. The local sense amplifier circuit disposed in the fifteenth local sense amplifier region LSAB15 may be connected to at least a part of the bit lines of the 1_14 sub-memory array SMA114", which is the normal region NR, and to at least a part of the bit lines of the 1_15 sub-memory array SMA115". The memory cell in the normal region NR may store the data DTA, and the local sense amplifier circuit in the fifteenth local sense amplifier region LSAB15 may be connected to a fifteenth global input/output line pair GIOp15. The local sense amplifier circuit in the fifteenth local sense amplifier region LSAB15 may input and output the data DTA stored by the memory cell in the 1_14 sub-memory array SMA114" and the 1_15 sub-memory array SMA115" through the fifteenth global input/output line pair GIOp15.

At least a part of the sixteenth local sense amplifier region LSAB16 may overlap the 1_15 sub-memory array SMA115" and the 1_16 sub-memory array SMA116" in the third direction D3. The local sense amplifier circuit disposed in the sixteenth local sense amplifier region LSAB16 may be connected to at least a part of the bit lines of the 1_15 sub-memory array SMA115", which is the normal region NR, and to at least a part of the bit lines of the 1_16 sub-memory array SMA116". The memory cell in the normal region NR may store the data DTA, and the local sense amplifier circuit in the sixteenth local sense amplifier region LSAB16 may be connected to a sixteenth global input/output line pair GIOp16. The local sense amplifier circuit in the sixteenth local sense amplifier region LSAB16 may input and output the data DTA stored by the memory cell in the 1_15 sub-memory array SMA115" and the 1_16 sub-memory array SMA116" through the fifteenth global input/output line pair GIOp16.

At least a part of the seventeenth local sense amplifier region LSAB17 may overlap the 1_16 sub-memory array SMA116" in the third direction D3. The local sense amplifier circuit disposed in the seventeenth local sense amplifier region LSAB17 may be connected to at least a part of the bit lines of the 1_16 sub-memory array SMA116", which is the normal region NR. The memory cell in the normal region NR may store the data DTA, and the local sense amplifier circuit in the seventeenth local sense amplifier region LSAB17 may be connected to a seventeenth global input/output line pair GIOp17. The local sense amplifier circuit in the seventeenth local sense amplifier region LSAB17 may input and output the data DTA stored by the memory cell in the 1_16 sub-memory array SMA116" through the seventeenth global input/output line pair GIOp17.

The first to seventeenth local sense amplifier regions LSAB1 to LSAB17 may be arranged in the second direction D2. The first to seventeenth local sense amplifier regions LSAB1 to LSAB17 may be disposed above the 1_1 to 1_16 sub-memory arrays SMA11" to SMA116" based on the first direction D1.

The first to eighth local sense amplifier regions LSAB1 to LSAB8 and the tenth to seventeenth local sense amplifier regions LSAB10 to LSAB17 may correspond to the normal region NR in the first row block RB1", and the ninth local sense amplifier region LSAB9 may correspond to the redundancy region RR in the first row block RB1". The normal region NR and the redundancy region RR may be divided based on the bit lines included in the first row block RB1". For example, the normal region NR and the redundancy region RR may be differentiated from each other based on bit lines connected thereto.

Depending on the embodiments, the first to seventeenth local sense amplifier regions LSAB1 to LSAB17 may include k bit line sense amplifiers. Accordingly, each of the local sense amplifier circuits included in the first to seventeenth local sense amplifier regions LSAB 1 to LSAB17 may be connected to 2k bit lines. Considering the number of bit lines connected to each of the local sense amplifier circuits of the first through seventeenth local sense amplifier regions LSAB1 through LSAB17, there may be 2k+X bit lines included in each of a plurality of sub-memory arrays SMA11" to SMA816". Depending on the embodiments, the k may be 256 and the X may be 32.

Depending on the embodiments, the ratio of the number of 2k bit lines connected to the local sense amplifier circuit in each of the first to seventeenth local sense amplifier regions LSAB1 to LSAB17 to the number of 2k+X bit lines included in each of the plurality of sub-memory arrays SMA11" to SMA816" may be 1 to x3. The x3 may be a rational number that is not an integer greater than 1. For example, x3 may be a rational number that is not a whole number greater than 1 (e.g., x3 is not 2, 3, 4, etc.). Depending on the embodiments, the x3 may be within 1.02 to 1.35, and preferably within 1.05 to 1.2. In other words, x3 may be in a range from 1.02 to 1.35 (e.g., in a range from 1.05 to 1.2).

The first row block RB 1" may allocate a region corresponding to a specific local sense amplifier circuit as the redundancy region RR through the arrangement of the plurality of the sub-memory arrays SMA11" to SMA816" and the first to seventeenth local sense amplifier regions LSAB1 to LSAB17, without arrangement of sub-memory arrays for ECC cells or redundancy cells. The arrangement of the first row block RB1" as described above may reduce the sub-word driver region disposed on the second bank array 210c (e.g., may reduce an area of the sub-word line driver region) and improve the area efficiency of the configurations within the memory device.

Although not shown, the memory device 10 may include a local sense amplifier region disposed on the lower side of the plurality of the sub-memory arrays SMA11" to SMA816" in the first direction D1, in addition to the first to seventeenth local sense amplifier regions LSAB1 to LSAB17 on the upper side.

Although not shown, at least a part of the first to seventeenth local sense amplifier regions LSAB1 to LSAB17 may overlap 2_1 to 2_16 sub-memory arrays SMA21" to SMA216" in the third direction D3. The local sense amplifier circuits disposed in the first to seventeenth local sense amplifier regions LSAB1 to LSAB17 may be connected to the bit lines of the 2_1 to 2_16 sub-memory arrays SMA21" to SMA216".

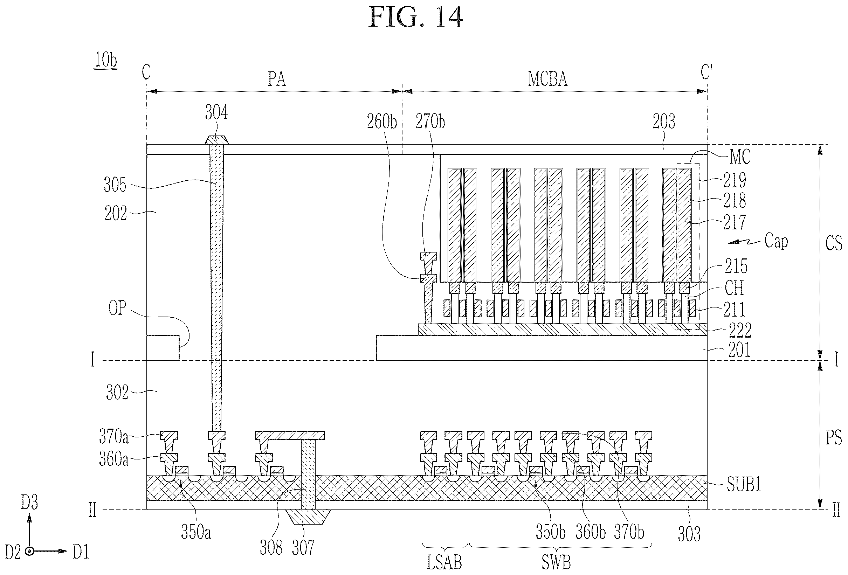

FIG. 14 is a cross-sectional view taken along line C-C' of the memory device of FIG. 4 according to some further embodiments. A memory device 10b may correspond to the memory device 10a of FIG. 8. For ease of explanation, the description will focus on the differences between the memory device 10b and the memory device 10a of FIG. 8.

Referring to FIGS. 8 and 14, when compared to the memory device 10a of FIG. 8, the lower bonding metals 381a, 382a, 381b, and 382b and the lower metal pattern 383b are not disposed in the peripheral circuit region PS of the memory device 10b, and the upper bonding metals 282a, 281b, and 282b and the upper metal pattern 283b are not disposed in the memory cell region CS of the memory device 10b.

Additionally, the bit line 222 may be disposed between the second metal layers 370a and 370b of the peripheral circuit region PS and the second metal layer 270b of the memory cell region CS. Accordingly, the second metal layer 270b of the memory cell region CS may be disposed above the bit line 222 in the third direction D3.

When compared to the memory device 10a of FIG. 8, the memory device 10b may include a horizontal semiconductor layer 201 disposed below the bit line 222 instead of the second substrate SUB2 disposed above the bit line 222.

The horizontal semiconductor layer 201 may include a lower support semiconductor layer (not shown) and a common source plate (not shown) on the lower support semiconductor layer. The horizontal semiconductor layer 201 may include, for example, at least one of silicon (Si), germanium (Ge), silicon germanium (SiGe), gallium arsenide (GaAs), indium gallium arsenide (InGaAs), aluminum gallium arsenide (AlGaAs), or a combination thereof. The horizontal semiconductor layer 201 may have a crystal structure including at least one selected from single crystal, amorphous, and polycrystal.

Depending on the embodiments, the horizontal semiconductor layer 201 may include an opening OP. Depending on the embodiments, the first interlayer insulating layer 302 and the second interlayer insulating layer 202 may be in contact through the opening OP. The second external contact plug 305 may extend along the third direction D3 through the opening OP, and penetrate a part of the second interlayer insulating layer 202 and the first interlayer insulating layer 302 to be electrically connected to the second metal layer 370a of the external pad bonding area PA. Depending on the embodiments, the second external contact plug 305 may be electrically connected to the circuit elements 350a within the external pad bonding area PA.

Additionally, the upper insulating layer 203 may cover the second metal layer 260b and the second interlayer insulating layer 202.

In FIG. 14, the second metal layers 370a and 370b of the peripheral circuit region PS and the second metal layer 270b of the memory cell region CS are not connected, but in some embodiments, at least one of the second metal layers 370a or 370b of the peripheral circuit region PS and the second metal layer 270b of the memory cell region CS may be electrically connected to each other.

Although not shown in FIG. 14, the circuit elements 350b disposed in the local sense amplifier region LSAB may be electrically connected to the bit lines 222 through the first and second metal layers 360b and 370b of the peripheral circuit region PS and the first and second metal layers 260b and 270b of the memory cell region CS. The circuit elements 350b disposed in the sub-word line driver region SWB may be electrically connected to the bit lines 222 through the first and second metal layers 360b and 370b of the peripheral circuit region PS and the first and second metal layers 260b and 270b of the memory cell region CS.

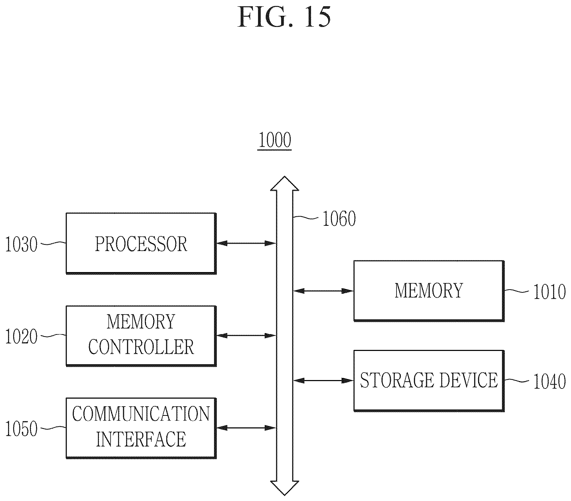

FIG. 15 is a block diagram illustrating a computer device according to some embodiments.

Referring to FIG. 15, a computing device 1000 (i.e., a computer device) includes a processor 1030, a memory 1010, a memory controller 1020, a storage device 1040, a communication interface 1050, and a bus 1060. Although not shown, the computing device 1000 may further include other general-purpose components.

The processor 1030 controls the overall operation of each component of the computing device 1000. The processor 1030 may be implemented with at least one of various processing units such as a central processing unit (CPU), an application processor (AP), and a graphics processing unit (GPU).

The memory 1010 stores various data and instructions. The memory 1010 may be implemented with a memory device described with reference to FIGS. 1 to 14. Depending on the embodiments, the memory 1010 may be a COP-structured volatile memory device. The memory 1010 may be a memory device with improved area efficiency by allocating a region corresponding to a specific local sense amplifier circuit as a redundancy region without arranging a sub-memory array for ECC cells or redundancy cells.

The memory controller 1020 may control input and output of data or commands in the memory 1010. In some embodiments, the memory controller 1020 may be provided as a separate chip from the processor 1030. In other embodiments, the memory controller 1020 may be provided as an internal component of the processor 1030.

The storage device 1040 stores programs and data non-volatilely. In some embodiments, the storage device 1040 may be implemented with a non-volatile memory. The communication interface 1050 supports wired and wireless Internet communication of the computing device 1000. Additionally, the communication interface 1050 may support various communication methods other than Internet communication. The bus 1060 provides communication functions between components of the computing device 1000. The bus 1060 may include at least one type of bus depending on the communication protocol between components.

## Claims

1. A memory device, comprising:
a memory cell region (CS) comprising a first sub-memory array (SMA11; SMA11'; SMA11") and a second sub-memory array (SMA12; SMA12'; SMA12'') arranged in a first direction (D2), wherein the first sub-memory array (SM11; SMA11'; SMA11") comprises a plurality of first volatile memory cells electrically connected to a first word line extending in the first direction (D2) and to respective ones of a plurality of first bit lines, and wherein the second sub-memory array (SMA12; SMA12'; SMA12'') comprises a plurality of second volatile memory cells electrically connected to a second word line extending in the first direction (D2) and to respective ones of a plurality of second bit lines; and
a peripheral circuit region (PS) comprising a first local sense amplifier circuit that at least partially overlaps the first sub-memory array (SMA11; SMA11'; SMA11") and the second sub-memory array (SMA12; SMA12'; SMA12'') in a second direction (D3) orthogonal to the first direction (D2),
wherein the first local sense amplifier circuit is electrically connected to at least one of the first bit lines and to at least one of the second bit lines, and
wherein a number of the first bit lines is equal to a number of the second bit lines.

2. The memory device of claim 1, wherein the peripheral circuit region (PS) further comprises a second local sense amplifier circuit that at least partially overlaps the first sub-memory array (SMA11; SMA11'; SMA11") in the second direction (D3), and
wherein the second local sense amplifier circuit is electrically connected to at least one of the first bit lines.

3. The memory device of claim 1 or 2, wherein the first bit lines and the second bit lines extend in a third direction (D1) orthogonal to the first and second directions (D2, D3).

4. The memory device of claim 3, wherein the first sub-memory array (SMA11; SMA11'; SMA11") and the second sub-memory array (SMA12; SMA12'; SMA12'') are included in a first bank array (210a), and
wherein the first sub-memory array (SMA11) and the second sub-memory array (SMA12) are divided into a first row block (RB1) in the first bank array (210a) based on one or more bits included in a row address.

5. The memory device of claim 4, wherein the first bank array (210a) further comprises third to eighth sub-memory arrays (SMA13 -SMA18) arranged in the first direction (D2) and divided into the first row block (RB1) based on the one or more bits included in the row address,
wherein the peripheral circuit region (PS) further comprises second to seventeenth local sense amplifier circuits that each at least partially overlap one or more of the first to eighth sub-memory arrays (SMA11 -SMA18) in the second direction (D3), and
wherein the first to seventeenth local sense amplifier circuits are arranged in the first direction (D2).

6. The memory device of claim 5, wherein the first to sixteenth local sense amplifier circuits are configured to output data (DTA), and the seventeenth local sense amplifier circuit is configured to output parity data (PRT) corresponding to the data (DTA), and
wherein a ratio of a number of bits of the data (DTA) to a number of bits of the parity data (PRT) is 16 to 1.

7. The memory device of claim 4, wherein the first bank array (210a) further comprises third and fourth sub-memory arrays (SMA13', SMA14') arranged in the first direction (D2) and divided into the first row block (RB1) based on the one or more bits included in the row address,
wherein the peripheral circuit region (PS) further comprises second to seventeenth local sense amplifier circuits that each at least partially overlap one or more of the first to fourth sub-memory arrays (SMA11'-SMA14') in the second direction (D3), and
wherein the first to seventeenth local sense amplifier circuits are arranged in the first direction (D2).

8. The memory device of any one of claims 1 to 7, wherein a number of the first volatile memory cells is equal to a number of the second volatile memory cells.

9. The memory device of any one of claims 1 to 8, wherein the peripheral circuit region (PS) further comprises a sub-word line driver electrically connected to the second word line, and
wherein the sub-word line driver is in a sub-word line driver region (SWB) that at least partially overlaps the second sub-memory array (SMA12; SMA12') in the second direction (D3).

10. The memory device of any one of claims 1 to 9, wherein the peripheral circuit region (PS) further comprises a substrate (SUB1), and
wherein the first volatile memory cells and the second volatile memory cells comprise a vertical channel layer (CH) extending in the second direction (D3) perpendicular to an upper surface of the substrate (SUB1).

11. The memory device of claim 10, wherein the vertical channel layer (CH) comprises at least one of silicon or indium gallium zinc oxide, IGZO.

12. The memory device of claim 1, wherein the peripheral circuit region (PS) further comprises a second local sense amplifier circuit that at least partially overlaps the second sub-memory array (SMA12') in the second direction (D3), and
wherein the second local sense amplifier circuit is electrically connected to at least one of the plurality of second bit lines.
wherein the first local sense amplifier circuit is configured to output data (DTA), and the second local sense amplifier circuit is configured to output parity data (PRT) corresponding to the data (DTA).

13. The memory device of claim 12, wherein the first sub-memory array (SMA11') is configured to store the data (DTA), and the second sub-memory array (SMA12') comprises a normal region (NR) configured to store the data (DTA) and a redundancy region (RR) configured to store the parity data (PRT),
wherein the normal region (NR) is differentiated from the redundancy region (RR) based on respective ones of the plurality of second bit lines.

14. The memory device of claim 12 or 13, wherein the first local sense amplifier circuit is electrically connected to a plurality of third bit lines and configured to the output data (DTA) through the plurality of third bit lines,
a ratio of the number of the third bit lines to the number of the first bit lines is 1 to x, and
wherein x is a rational number that is not a whole number and that is greater than 1.

15. The memory device of claim 14, wherein x is in a range from 2.1 to 2.3.
